# EUROPEAN PATENT APPLICATION

(11) **EP 2 642 510 A2**
(43) Date of publication of application: **25.09.2013**
(21) Application number: 12193742.9
(22) Date of filing: 22.11.2012
(51) Int. Cl.: H01L 21/02, H01L 21/316

(54) **Composition for forming ferroelectric thin film, method for forming ferroelectric thin film, ferroelectric thin film, and complex electronic component**

(30) Priority: 28.11.2011 JP 2011258689; 24.08.2012 JP 2012184832
(71) Applicant: Mitsubishi Materials Corporation, Chiyoda-ku Tokyo (JP)
(72) Inventor: Fujii, Jun, Naka-shi, Ibaraki (JP); Sakurai, Hideaki, Naka-shi, Ibaraki (JP); Soyama, Nobuyuki, Sanda-shi, Hyogo (JP)
(74) Representative: Gille Hrabal

(57) **Abstract**

A composition for forming a ferroelectric thin film is a composition for forming a ferroelectric thin film consisting of a lead titanate-based perovskite film or a lead zirconate titanate-based complex perovskite film. The composition includes lead acetate, a stabilizing agent consisting of acetylacetone or diethanolamine, and polyvinylpyrrolidone. The ratio of the molar number of the monomer-converted polyvinylpyrrolidone to the molar number of the perovskite B site atoms included in the composition is more than 0 and less than 0.015. The weight-average molecular weight of the polyvinylpyrrolidone is 5,000 to 100,000.

## Description

### TECHNICAL FIELD

The present invention relates to a composition for forming a ferroelectric thin film suitable for use in a thin film capacitor having a high capacity and a high density and the like, a method of forming the ferroelectric thin film, a ferroelectric thin film formed by the method, and a complex electronic component having the ferroelectric thin film.
The present application claims priority on Japanese Patent Application No. 2011-258689 filed on November 28, 2011 and Japanese Patent Application No. 2012-184832 filed on August 24, 2012, the contents of which are incorporated herein by reference.

### BACKGROUND ART

In the past, a ferroelectric thin film has been manufactured by the following method (for example, Patent Document 1). Firstly, a precursor for forming one kind of dielectric selected from lead titanate (PT), lead zirconate titanate (PZT), and the like is dissolved in an organic solvent mainly including at least one kind selected from lower alcohols, β-diketones, and the like so as to prepare a precursor solution for forming a dielectric. The precursor solution for forming a dielectric is coated on a metal substrate and dried so as to form a coated film of a precursor for forming a dielectric. Subsequently, the coated film is calcined at a temperature that is equal to or higher than the decomposition temperature of organic substances in the coated film and is equal to or lower than the crystallization temperature of the dielectric. The coating, the drying, and the calcination of the precursor solution for forming a dielectric are repeated. Subsequently, the coated film is fired at a temperature that is equal to or higher than the crystallization temperature of the dielectric. Alternatively, the coating of the precursor solution for forming a dielectric on the metal substrate, the drying, and the firing at a temperature that is equal to or higher than the crystallization temperature of the precursor are repeated. Thereby, two or more layers of thin films such as lead titanate (PT), lead zirconate titanate (PZT), and the like are formed on the metal substrate so as to manufacture a ferroelectric thin film. In the above-described method for manufacturing a ferroelectric thin film, it is possible to form a crystallized thin film of a dielectric on a metal substrate, and the film has a desired film thickness, is not conductive, and exhibits ferroelectricity.

In addition, the following method of forming a ferroelectric film has also been disclosed (for example, refer to Patent Document 2). Firstly, hydrated lead fatty acid salt is diluted in an alcohol solvent so as to prepare a solution, and then the solution is boiled so as to form a lead fatty acid salt from which water of crystallization is removed. Titanium alkoxide as a raw material is diluted in an alcohol solvent so as to prepare a solution. Next, the solution is boiled at a temperature that is equal to or higher than the boiling point of an alcohol obtained through hydrolysis of alkoxy groups in the titanium alkoxide so as to cause an alcohol exchange of the alkoxy groups and the alcohol in the solvent; and thereby, alcohol-exchanged titanium alkoxide is formed. Zirconium alkoxide as a raw material is diluted in an alcohol solvent so as to prepare a solution. Next, the solution is boiled at a temperature that is equal to or higher than the boiling point of an alcohol obtained through hydrolysis of alkoxy groups in the zirconium alkoxide so as to cause an alcohol exchange of the alkoxy groups and the alcohol in the solvent; and thereby, alcohol-exchanged zirconium alkoxide is formed. Then, the lead fatty acid salt from which crystallization water is removed, the alcohol-exchanged titanium alkoxide, and the alcohol-exchanged zirconium alkoxide are mixed. Subsequently, the mixture is boiled at a temperature that is equal to or higher than the boiling point of an ester obtained from the alcohol in the alcohol solvent and the fatty acid which is a component of the lead fatty acid salt; and thereby, lead titanium double alkoxides and lead zirconium double alkoxides are formed. Then, a reaction product including lead titanium double alkoxides and lead zirconium double alkoxide is cooled to room temperature, and then an alcohol solvent is added so as to adjust the concentration. Furthermore, the reaction product is hydrolyzed through addition of water and stirring, and the reaction product is polymerized through a condensation reaction. In addition, a fourth metal element such as lanthanum, niobium, iron or the like is added. Thereby, a raw material solution is prepared through polymerization of the reaction product. Subsequently, the raw material solution is coated on a substrate, and the coated raw material solution is dried so as to form a dried film. In addition, the dried film is sintered so as to form a ferroelectric film.

This method of forming a ferroelectric film is a method of forming a ferroelectric film consisting of lead zirconate titanate by the sol-gel method, and in detail, the method includes the following processes.
(a) A process in which lead fatty acid salt is obtained.
(b) A process in which titanium alkoxide is obtained.
(c) A process in which zirconium alkoxide having the same alcohol residue (alkoxy group) as the alcohol residue (alkoxy group) of the titanium alkoxide is obtained.
(d) A process in which the lead fatty acid salt, the titanium alkoxide, and the zirconium alkoxide are mixed so as to form lead titanium double alkoxide and lead zirconium double alkoxide.
The two kinds of double alkoxides formed in the process (d) have the same alcohol residue. Thereby, the subsequent hydrolysis and condensation reaction are substantially the same for the respective double alkoxides, and proceed uniformly. As a result, obtained metallic oxides have the same alcohol residue (alkoxy group) in high-molecular compounds, and the metallic oxides have a constant molecular structure (there is no composition deviation). In addition, only a few kinds of byproducts are formed, and the byproducts can be easily removed. Therefore, it is possible to suppress the composition deviation of the obtained high-molecular compounds. The intermolecular stress due to decomposition of an organic group can be alleviated. In addition, it is possible to decrease the density of defects such as pores. A PZT thin film formed from the sol-gel solution has a flat and smooth surface, a large residual polarization, and a small leakage current. Therefore, the PZT thin film has sufficient electrical characteristics, and can satisfy performances in demand.

However, in the method of manufacturing a ferroelectric thin film disclosed in Patent Document 1 of the related art or the method of forming a ferroelectric film disclosed in Patent Document 2 of the related art, a large stress is present due to fixation of the substrate, and, due to the action of the stress, there has been a problem in that it has not been possible to increase the relative permittivity of the ferroelectric thin film or the ferroelectric film.

In order to solve the above-described problem, Non-Patent Document 1 and Patent Document 3 are disclosed. Non-Patent Document 1 relates to the doping effects of cerium in a fine structure and the electrical characteristics of a PZT thin film obtained by the sol-gel method.
Non-Patent Document 1 discloses the following matters.
The insulation characteristics and ferroelectricity of a PZT thin film are improved by doping not more than 1 atomic% of Ce.
The optimal doped amount of Ce is effective to reduce the leakage current density and to increase the dielectric breakdown strength of a PZT thin film.
In a Ce-doped PZT thin film, the permittivity is increased by doping 1 atomic% of Ce. In the case where the doped amount of Ce is not more than 1 atomic%, the dielectric tangent is almost constant, and, in the case where the doped amount of Ce exceeds 1 atomic%, the permittivity decreases, and the dielectric loss increases.

Meanwhile, Patent Document 3 discloses a method of forming a lead zirconate titanate-based complex perovskite film by the sol-gel method. In this method, a sol including lead nitrate and acetylacetone is manufactured, and then the sol is gelated so as to manufacture a gel film. Then, the gel film is fired so as to form a lead zirconate titanate-based complex perovskite film. In this method, the contents of components in the sol is adjusted so that the molar number of acetylacetone becomes 0.25 times to 40 times the molar number of the perovskite A site atoms included in the sol. In addition, the gel film includes hydrophilic polymers having pyrrolidone groups. Furthermore, the above-described method of preparing a sol (coating fluid) is carried out in the following manner. Firstly, lead nitrate is added to an alcohol solvent such as 2-methoxyethanol, and the lead nitrate is dissolved so as to prepare an alcohol solution. Subsequently, a hydrophilic polymer having a pyrrolidone group such as polyvinylpyrrolidone is added to the alcohol solution, and is dissolved in the alcohol solution. Next, acetylacetone is added to the alcohol solution. Then, a zirconium alkoxide such as zirconium tetra normal propoxide, an alcohol such as 1-propanol, and a titanium alkoxide such as titanium tetraisopropoxide are added while stirring the alcohol solution. Also, as necessary, the alcohol solution is stirred while being heated at a temperature, for example, 70°C. Then, the alcohol solution is cooled to room temperature, and is allowed to stand. Thereby, a sol (coating fluid) is prepared.

In the method of Patent Document 3, in the case where the sol includes lead acetate trihydrate and acetylacetone, cracking occurs in a thick complex perovskite film. In contrast, in the case where the sol includes lead nitrate and acetylacetone, a thick complex perovskite film can be formed without the occurrence of cracking. In addition, in Patent Document 3, the molar number of acetylacetone is 0.25 times to 40 times the molar number of the perovskite A site atoms included in the sol. Thereby, a thicker complex perovskite film can be formed without the occurrence of cracking. Furthermore, since the gel film includes hydrophilic polymers having pyrrolidone groups, it becomes possible to form a even thicker complex perovskite film without the occurrence of cracking.

However, in Non-Patent Document 1 of the related art, it is necessary to dope 1 atomic% or less of Ce to the PZT thin film in order to improve the insulation characteristics and ferroelectricity of the PZT thin film and to reduce the leakage current density. Therefore, there is a disadvantage that the number of manufacturing processes of the PZT thin film increases. In addition, in the method of forming a lead zirconate titanate-based complex perovskite film disclosed in Patent Document 3 of the related art, in the case where not lead nitrate but lead acetate is included in the sol and the complex perovskite film is thick, there has been a problem in that cracking occurs in the film.

### PRIOR ART DOCUMENT

### Patent Document

Patent Document 1: Japanese Unexamined Patent Application, First Publication No. S60-236404 (claim 1, lines 14 to 16 in the left bottom column on page 5 in the specification)
Patent Document 2: Japanese Unexamined Patent Application, First Publication No. H07-252664 (claims 2, 3, 7, and 8, paragraphs [0117] and [0118])
Patent Document 3: Japanese Unexamined Patent Application, First Publication No. 2002-293623 (claims 1 to 3, paragraphs [0006], [0013], Table 1 in [0021])

### Non-Patent Document

Non-Patent Document 1: S. B. Majumder, D. C. Agrawal, Y. N. Mohapatra, and R. S. Katiyar, "Effect of cerium doping on the micro-structure and electrical properties of sol-gel derived Pb1.05(Zr0.53-δCeδTi0.47)O3 (δ≤ 10 at.%) thin films", Materials Science and Engineering, B98, (2003), pp. 25 to 32 (Abstract on Page 25, Fig. 2 on Page 27, lines 4 to 8 in "3.2. Electrical Characteristics" in the left column on Page 28)

### DISCLOSURE OF THE INVENTION

### Problems to be Solved by the Invention

An object of the present invention is to provide a composition for forming a ferroelectric thin film which does not cause cracking in a relatively thick thin film even when containing lead acetate instead of lead nitrate, a method of forming a ferroelectric thin film, a thin film formed by this method, and a complex electronic component having the thin film. Another object of the present invention is to provide a composition for forming a ferroelectric thin film which can manufacture a thin film capacitor and the like having a high capacity and a high density even when Ce is not included, a method of forming a ferroelectric thin film, a thin film formed by this method, and a complex electronic component having the thin film.

### Means for Solving the Problems

A first aspect of the invention is a composition for forming a ferroelectric thin film which is a composition for forming a ferroelectric thin film consisting of a lead titanate-based perovskite film or a lead zirconate titanate-based complex perovskite film. The composition includes lead acetate, a stabilizing agent consisting of acetylacetone or diethanolamine, and polyvinylpyrrolidone. A ratio of a molar number of monomer-converted polyvinylpyrrolidone to a molar number of perovskite B site atoms included in the composition is in a range of more than 0 to less than 0.015. A weight-average molecular weight of the polyvinylpyrrolidone is in a range of 5,000 to 100,000.

A second aspect of the invention is the invention according to the first aspect, in which the lead titanate-based perovskite film or the lead zirconate titanate-based perovskite film may be represented by a general formula [(PbₓLa_{y})(Zr_{z}Ti_{(1-z)})O₃]. Here, in the general formula, 0.9 < x < 1.3, 0 ≤ y < 0.1, and 0 ≤ z < 0.9 are fulfilled.

A third aspect of the invention is the invention according to the first aspect, in which the composition may further include a raw material containing metal elements that form the lead titanate-based perovskite film or the lead zirconate titanate-based complex perovskite film. The raw material may be a compound in which organic groups are bound to the metal elements through oxygen atoms or nitrogen atoms.

A fourth aspect of the invention is the invention according to the third aspect, in which the raw material containing metal elements that form the lead titanate-based perovskite film or the lead zirconate titanate-based complex perovskite film may be one or more selected from a group consisting of organic acid salts, metal alkoxides, metal β-diketonate complexes, metal β-diketoester complexes, metal β-iminoketo complexes, and metal amino complexes.

A fifth aspect of the invention is the invention according to any one of the first to fourth aspects, in which an amount of the stabilizing agent may be in a range of 0.2 parts by mole to 3 parts by mole with respect to one part by mole of a total amount of the metal elements in the composition.

A sixth aspect of the invention is the invention according to the first aspect, in which a ratio of a molar number of monomer-converted polyvinylpyrrolidone to a molar number of perovskite B site atoms included in the composition may be in a range of 0.001 to 0.01.

A seventh aspect of the invention is a method for forming a ferroelectric thin film. The method includes: a coating process in which the composition for forming a ferroelectric thin film according to any one of the first to sixth aspects is coated on a substrate so as to form a coated film; a drying process in which the coated film formed on the substrate is heated and dried in any atmosphere selected from air, an oxidization atmosphere, and a water vapor-containing atmosphere; and a firing process in which the coated film is fired at a temperature of not lower than a crystallization temperature in an atmosphere consisting of one or more gases selected from O₂, N₂, Ar, N₂O, H₂, dried air, and water vapor from a middle of the drying process or after completion of the drying process.

An eighth aspect of the invention is a method for forming a ferroelectric thin film. The method includes: a coating process in which the composition for forming a ferroelectric thin film according to any one of the first to sixth aspects is coated on a substrate so as to form a coated film; a drying process in which the coated film formed on the substrate is heated and dried in any atmosphere selected from air, an oxidization atmosphere, and a water vapor-containing atmosphere; a repetition process in which the coating process and the drying process are repeated a plurality of times; and a firing process in which the coated film is fired at a temperature of not lower than a crystallization temperature in an atmosphere consisting of one or more gases selected from O₂, N₂, Ar, N₂O, H₂, dried air, and water vapor from a middle of a final drying process in the repetition process or after completion of the final drying process in the repetition process.

A ninth aspect of the invention is a ferroelectric thin film which is formed by the method according to the seventh or eighth aspect.

A tenth aspect of the invention is a complex electronic component. The complex electronic component includes an element having the ferroelectric thin film of the ninth aspect. The element is any one selected from thin film capacitors, capacitors, IPDs, DRAM memory capacitors, laminate capacitors, gate insulators of transistors, non-volatile memories, pyroelectric infrared detecting elements, piezoelectric elements, electro-optic elements, actuators, resonators, ultrasonic motors, surface acoustic wave elements, transducers, and LC noise filter elements.

An eleventh aspect of the invention is a complex electronic component. The complex electronic component includes an element having the ferroelectric thin film according to the ninth aspect which corresponds to a frequency range of 100 MHz or more. The element is any one selected from thin film capacitors, capacitors, IPDs, DRAM memory capacitors, laminate capacitors, gate insulators of transistors, non-volatile memories, pyroelectric infrared detecting elements, piezoelectric elements, electro-optic elements, actuators, resonators, ultrasonic motors, surface acoustic wave elements, transducers, and LC noise filter elements.

### Effects of the Invention

The ferroelectric thin film forming composition according to the first aspect of the invention has the following features.
The composition includes: lead acetate; a stabilizing agent consisting of acetylacetone or diethanolamine; and polyvinylpyrrolidone.
The ratio of the molar number of the monomer-converted polyvinylpyrrolidone to the molar number of the perovskite B site atoms included in the composition is in a range of more than 0 to less than 0.015.
The weight-average molecular weight of the polyvinylpyrrolidone is in a range of 5,000 to 100,000.
As a result, cracking does not occur in the formed ferroelectric thin film even in the case where Ce is not doped to the composition, and the composition contains lead acetate instead of lead nitrate. Cracking does not easily occur even in the case where the ferroelectric thin film is relatively thick. In addition, when, for example, a ferroelectric thin film of a thin film capacitor is manufactured using the composition for forming a ferroelectric thin film, it is possible to obtain a thin film capacitor having a high capacity and a high density.

In the composition for forming a ferroelectric thin film according to the third aspect of the invention, the raw material containing metal elements that form the lead titanate-based perovskite film or the lead zirconate titanate-based complex perovskite film is a compound in which organic groups are bound to the metal elements through oxygen atoms or nitrogen atoms.
Therefore, the included heterogeneous metal elements form a crosslinking bond through oxygen atoms or nitrogen atoms. As a result, the storage stability of the composition is enhanced compared to the case where heterogeneous metal elements are simply mixed. In addition, it is possible to decrease the crystallization temperature in a firing process of the composition, and to enhance the uniformity of the composition of a fired thin film.

In the composition for forming a ferroelectric thin film according to the fifth aspect of the invention, the amount of the stabilizing agent is in a range of 0.2 parts by mole to 3 parts by mole with respect to one part by mole of the total amount of the metal elements in the composition.
Therefore, the storage stability of the composition is enhanced, and a hydrolysis reaction in the air is suppressed; and therefore, it becomes easy to handle the composition in the air.

The method for forming a ferroelectric thin film according to the seventh aspect of the invention includes the following processes.
A process in which the composition for forming a ferroelectric thin film is coated on a substrate so as to form a coated film.
A process in which the coated film formed on the substrate is heated and dried in an atmosphere such as air, or the like.
A process in which the coated film is fired at a temperature of not lower than the crystallization temperature from the middle of the drying process or after completion of the drying process.
As a result, it is possible to easily form a ferroelectric thin film on a substrate with no occurrence of cracking.

The method for forming a composition for forming a ferroelectric thin film according to the eighth aspect of the invention includes the following processes.
A process in which the composition for forming a ferroelectric thin film is coated on a substrate so as to form a coated film.
A process in which the coated film formed on the substrate is heated and dried in an atmosphere such as air or the like.
A process in which the coating process and the drying process are repeated a plurality of times.
A process in which the coated film is fired at at a temperature of not lower than the crystallization temperature from the middle of a final drying process in the repetition process or after completion of the final drying process in the repetition process.
As a result, it is possible to easily form a ferroelectric thin film on a substrate with no occurrence of cracking.

### BEST MODE FOR CARRYING OUT THE INVENTION

Next, embodiments for carrying out the invention will be described.

### (Composition for forming a ferroelectric thin film)

The composition for forming a ferroelectric thin film of the present embodiment is used to form a ferroelectric thin film consisting of a lead titanate-based perovskite film or a lead zirconate titanate-based complex perovskite film. The composition includes lead acetate, a stabilizing agent consisting of acetylacetone or diethanolamine, and polyvinylpyrrolidone.

The composition contains metal elements in a ratio that fulfills the composition formula (PbₓLa_{y})(Zr_{z}Ti_{(1-z)}) (0.9 < x < 1.3, 0≤y < 0.1, and 0≤z < 0.9).

A film formed using the composition is represented by a general formula [(PbₓLa_{y})(Zr_{z}Ti_{(1-z)})O₃] (0.9 < x < 1.3, 0≤y < 0.1, and 0≤z < 0.9) as shown below, and the film has a perovskite structure. In the perovskite structure, Pb and La are located in the A sites, and Zr and Ti are located in the B sites. One mole of a compound represented by the general formula [(PbₓLa_{y})(Zr_{z}Ti_{(1-z)})O₃] (0.9 <x< 1.3, 0≤y < 0.1, and 0≤z < 0.9) includes a total amount of 1 mole of Zr and Ti. Therefore, the molar number of the total contents af Zr and Ti included in the composition matches the molar number of a compound of a film formed using the composition.

The ratio of the molar number (molar ratio) of the monomer-converted polyvinylpyrrolidone to the molar number of the total content of Zr and Ti (the perovskite B site atoms) included in the composition is in a range of more than 0 to less than 0.015, and preferably in a range of 0.001 to 0.01. This molar ratio also represents the ratio of the molar number of the amount of the monomer-converted polyvinylpyrrolidone to the molar number of a compound of a film formed using the composition.

The weight-average molecular weight of the polyvinylpyrrolidone included in the composition is in a range of 5,000 to 100,000, and preferably in a range of 10,000 to 50,000.

Here, the reasons why the ratio of the molar number (molar ratio) of the amount of the monomer-converted polyvinylpyrrolidone to the molar number of the amount of the perovskite B site atoms is limited within a range of more than 0 to less than 0.015 will be described below. In the case where the molar ratio is zero, the effect of the polyvinylpyrrolidone, that is, the effect of increasing the electrical capacity of a fired thin film cannot be obtained. In the case where the molar ratio is 0.015 or more, a fired thin film becomes porous, and the electrical capacity decreases.

The reasons why the weight-average molecular weight of the polyvinylpyrrolidone is limited within a range of 5,000 to 100,000 will be described below. In the case where the weight-average molecular weight of the polyvinylpyrrolidone is less than 5,000, the effect of increasing the electrical capacity of a fired thin film cannot be obtained. In the case where the weight-average molecular weight of the polyvinylpyrrolidone exceeds 100,000, a fired thin film becomes porous, and the electrical capacity decreases.

Meanwhile, the polyvinylpyrrolidone refers to a hydrophilic polymer having pyrrolidone groups.

Meanwhile, a lead titanate (PT, PbTiO₃) film can be used as the lead titanate-based perovskite film. A lead zirconate titanate (PZT, Pb(Zr, Ti)O₃) film, a lead lanthanum zirconate titanate (PLZT, (Pb, La) (Zr, Ti)O₃) film, or the like can be used as the lead zirconate titanate -based complex perovskite film. That is, the lead titanate-based perovskite film or the lead zirconate titanate -based complex perovskite film is represented by the general formula [(PbₓLa_{y})(ZrTi_{(1-z)})O₃]- In the general formula, 0.9 <x< 1.3, 0≤y<0.1, and 0≤z < 0.9 are fulfilled. In the case where y ≠ 0 and z ≠ 0 are fulfilled in the general formula, the general formula represents lead lanthanum zirconate titanate (PLZT). In the case where y = 0 and z ≠ 0 are fulfilled, the general formula represents lead zirconate titanate (PZT). In the case where y = 0 and z = 0 are fulfilled, the general formula represents lead titanate (PT).
Here, the reasons why the x in the general formula is limited within a range of 0.9 < x < 1.3 will be described below. In the case where x is 0.9 or less, a pyrochlore phase appears in a fired thin film, and the electrical capacity greatly decreases. In the case where x is 1.3 or more, an excessive amount of lead appears in the form of lead oxide in a fired thin film, and the electrical capacity greatly decreases.
The reasons why the y in the general formula is limited within a range of 0≤y< 0.1 will be described below. In the case where y is 0.1 or more, the electrical capacity of a fired thin film greatly decreases.
The reasons why the z in the general formula is limited within a range of 0≤z< 0.9 will be described below. In the case where z is 0.9 or more, the electrical capacity of a fired thin film greatly decreases.

The composition further includes a raw material containing metal elements that compose the lead titanate-based perovskite film or the lead zirconate titanate-based complex perovskite film. The raw material is preferably a compound in which organic groups are bound to the metal elements through oxygen atoms or nitrogen atoms. The reasons thereof will be described below.
In the composition containing the above-described compound, the included heterogeneous metal elements form a crosslinking bond through oxygen atoms or nitrogen atoms. Therefore, the storage stability of the composition is enhanced compared to the case where the heterogeneous metal elements are simply mixed. In addition, it is possible to decrease the crystallization temperature in a firing process of the composition. Furthermore, it is possible to enhance the uniformity of the composition of a fired thin film.
Examples of the compound include one or more selected from a group consisting of organic acid salts, metal alkoxides, metal β-diketonate complexes, metal β-diketoester complexes, metal β-iminoketo complexes, and metal amino complexes. The organic acid salts are particularly preferable compounds.

Among the above-described compounds, examples of a Pb compound (Pb source) include an acetate salt (lead acetate).
Examples of a La compound (La source) include organic acid salts, metal alkoxides, and metal β-diketonate complexes.
Examples of the organic acid salts include acetates (lanthanum acetate), propionates (lanthanum propionate), butyrates (lanthanum butyrate), octylates (lanthanum octylate), primary carboxylates (lanthanum carboxylate), and the like.
Examples of the metal alkoxides include lanthanum triisopropoxide, lanthanum tributoxide (lanthanum tetra-n-butoxide, lanthanum tetra-i-butoxide, lanthanum tetra-t-butoxide), lanthanum alkoxide coordinated with a monovalent alcohol, lanthanum methoxyethoxide, lanthanum ethoxyethoxide, lanthanum alkoxyalkoxide, and the like.
Examples of the metal β-diketonate complexes include lanthanum acetylacetonate, hepta-fluorobutanoylpivaloylmethanato lanthanum, dipivaloylmethanato lanthanum, lanthanum trifluoroacetylacetate, lanthanum benzoylacetonate, and the like.

Examples of a Ti compound (Ti source) include Ti alkoxides coordinated with a monovalent alcohol, metal alkoxide, and metal β-diketonate complexes.
Examples of the Ti alkoxides coordinated with a monovalent alcohol include Ti tetraethoxide, Ti tetraisopropoxide (hereinafter referred to as Ti isopropoxide), Ti tetrabutoxide (Ti tetra-n-butoxide, Ti tetra-i-butoxide, Ti tetra-t-butoxide), Ti dimethoxy diisopropoxide, and the like.
Examples of the metal alkoxides include Ti methoxyethoxide, Ti ethoxyethoxide, Ti alkoxyalkoxide, and the like.
Examples of the metal β-diketonate complexes include Ti acetylacetonate, hepta-fluorobutanoylpivaloylmethanato Ti, dipivaloylmethanato Ti, Ti trifluoroacetylacetate, Ti benzoylacetonate, and the like.

Examples of a Zr compound (Zr source) include Zr alkoxides coordinated with a monovalent alcohol, metal alkoxides, and metal β-diketonate complexes.
Examples of the Zr alkoxides coordinated with a monovalent alcohol include Zr tetraethoxide, Zr tetraisopropoxide, Zr tetrabutoxide (Zr tetra-n-butoxide, Zr tetra-i-butoxide, Zr tetra-t-butoxide), Zr dimethoxy diisopropoxide, and the like.
Examples of the metal alkoxide include Zr methoxyethoxide, Zr ethoxyethoxide, Zr alkoxyalkoxide, and the like.
Examples of the metal β-diketonate complexes include Zr acetylacetonate, hepta-fluorobutanoylpivaloylmethanato Zr, dipivaloylmethanato Zr, Zr trifluoroacetylacetate, Zr benzoylacetonate, and the like.
Meanwhile, the metal alkoxide may be used as it is; however, the partially hydrolyzed metal alkoxide may be used in order to accelerate decomposition.

The Pb compound (Pb source), the La compound (La source), the Ti compound (Ti source), and the Zr compound (Zr source) may be included in the composition as they are. In addition, they may be used as starting materials in the method of manufacturing the composition as described below.

### (Method of manufacturing the composition for forming a ferroelectric thin film)

A preparing method (manufacturing method) of the composition having the above-described characteristics will be explained.
For example, in order to prepare a composition for forming a PLZT film, firstly, a Zr compound (Zr source), a Ti compound (Ti source), and a stabilizing agent are fed into a reaction vessel, and the mixture is refluxed in an inert gas atmosphere such as nitrogen gas or the like at a temperature of 80°C to 200°C; and thereby, an organic metal compound containing Zr and Ti is obtained.
The added amount of the stabilizing agent is preferably in a range of 0.2 parts by mole to 3 parts by mole, and more preferably in a range of 1 part by mole to 2 parts by mole with respect to one part by mole of the total amount of the metal elements in the composition. That is, the stabilizing agent is included so that (the number of molecules of the stabilizing agent)/(the number of atoms of the metal elements) becomes preferably in a range of 0.2 to 3, and more preferably in a range of 1 to 2.
Here, the reasons why the amount of the stabilizing agent is limited within a range of 0.2 parts by mole to 3 parts by mole with respect to one part by mole of the total amount of the metal elements in the composition will be described. In the case where the amount of the stabilizing agent is less than 0.2 parts by mole, stabilization of an obtained composition is not sufficient. Therefore, the storage stability of the composition deteriorates, and the composition gelates or precipitates are easily formed. In the case where the amount of the stabilizing agent exceeds 3 parts by mole, the film formation properties or the electric characteristics of a thin film deteriorates.

Next, the Pb compound (Pb source), the La compound (La source), and a solvent are added to the organic metal compound containing Zr and Ti, and the mixture is refluxed in an inert gas atmosphere such as nitrogen gas or the like at a temperature of 80°C to 200°C; and thereby, an organic metal compound containing Zr, Ti, Pb, and La is obtained.
A solution (organic metal compound solution) including the organic metal compound containing Zr, Ti, Pb, and La is distilled at a reduced pressure so as to remove byproducts.
Subsequently, a solvent is further added to the solution so as to adjust the concentration. Thereby, a solution including a metal compound (the organic metal compound containing Zr, Ti, Pb, and La) at a predetermined oxide-converted concentration is obtained.
A solvent is appropriately determined depending on a raw material being used, and, in general, it is possible to use one solvent or a mixture of two or more solvents selected from carboxylic acids, alcohols, esters, ketones, ethers, cycloalkanes, aromatic compounds, and tetrahydrofuran. Among them, propylene glycol is particularly preferable.

Specific examples of the carboxylic acids that are preferably used include n-butyric acid, α-methyl butyric acid, i-valeric acid, 2-ethyl butyric acid, 2,2-dimethyl butyric acid, 3,3-dimethyl butyric acid, 2,3-dimethyl butyric acid, 3-methyl pentanoic acid, 4-methyl pentanoic acid, 2-ethyl pentanoic acid, 3-ethyl pentanoic acid, 2.2-dimethyl pentanoic acid, 3,3-dimethyl pentanoic acid, 2,3-dimethyl pentanoic acid, 2-ethylhexanoic acid, and 3-ethylhexanoic acid.
Examples of the alcohols that are preferably used include 1-propanol, 2-propanol, 1-butanol, 2-butanol, isobutyl alcohol, 1-pentanol, 2-pentanol, 2-methyl-2-pentanol, and 2-methoxyethanol.
Examples of the esters that are preferably used include ethyl acetate, propyl acetate, n-butyl acetate, sec-butyl acetate, tert-butyl acetate, isobutyl acetate, n-amyl acetate, sec-amyl acetate, tert-amyl acetate, and isoamyl acetate.
Examples of the ketones include acetone and methyl ethyl ketone.
Examples of the ethers include dimethyl ether and diethyl ether.
Examples of the cycloalkanes include cyclohexane and cyclohexanol.
Examples of the aromatic compounds include benzene, toluene, and xylene.

Next, a diluted alcohol is added to the organic metal compound solution. Thereby, a solution containing a metal compound at a predetermined oxide-converted concentration is obtained. In the solution, the molar ratio (Pb/La/Zr/Ti) of the respective metal elements is a predetermined ratio.
Furthermore, PVP is added to the solution so that the ratio of the molar number of the amount of the monomer-converted polyvinylpyrrolidone (PVP) to 100 mole% of the molar number of the total amount of Zr and Ti included in the solution (the molar number of the amount of PLZT molecules to be formed) is in a range of more than 0 mole% to less than 1.5 mole%, and preferably in a range of 0.1 mole% to 1.0 mole%. That is, PVP is added to the above-described solution so that the ratio of the molar number of the amount of the monomer-converted PVP to the molar number of the amount of PLZT molecules to be formed is in a range of more than 0 to less than 0.015, and preferably in a range of 0.001 to 0.01. Thereby, the composition of the embodiment is obtained.
Here, 100 mole% of the amount of the PLZT molecules to be formed is equivalent to 100 mole% of the amount of the perovskite B site atoms in PLZT. That is, one mole of PLZT molecules includes 1 mole of the perovskite B site atoms (Zr and Ti). Therefore, the ratio of the molar number of the amount of the monomer-converted polyvinylpyrrolidone to the molar number of the total amount of Zr and Ti included in the composition is in a range of more than 0 to less than 0.015, and preferably in a range of 0.001 to 0.01.
The weight-average molecular weight of the PVP is in a range of 5,000 to 100,000, and preferably in a range of 10,000 to 50,000. Furthermore, the total concentration of the organic metal compound in the composition is preferably approximately in a range of 0.1% by mass to 20% by mass in terms of the metal oxide-converted amount.

Next, the particles of the byproducts are removed from the composition. It is preferable to subject the composition to a filtration treatment so as to reduce the number of the particles having particle diameters of 0.5 µm or more (preferably 0.3 µm or more, and more preferably 0.2 µm or more) to 50 particles or less per one milliliter of the solution. In the case where the number of the particles having particle diameters of 0.5 µm or more in the composition exceeds 50 particles/milliliter, the long-term storage stability deteriorates. It is preferable to decrease the number of the particles having particle diameters of 0.5 µm or more in the composition as much as possible, and the number of the particles having particle diameters of 0.5 µm or more is particularly preferably 30 particles/milliliter or less.
A method of treating the composition in order to decrease the number of the particles to the above-described value is not particularly limited; however, examples of the method include the following three methods.
A first method is a filtration method in which a commercially available membrane filter having a pore diameter of 0.2 µm is used, and the composition is pumped using a syringe. A second method is a pressurized filtration method in which a commercially available membrane filter having a pore diameter of 0.05 µm and a pressurized tank are combined. A third method is a circulating filtration method in which the filter used in the second method and a solution circulating tank are combined.
In any method, the particle capture rate by a filter varies depending on the solution pumping pressure. It is generally known that the capture rate increases as the pressure decreases. Particularly, in the first and second methods, the solution is preferably filtered through a filter extremely slowly at a low pressure in order to make the number of the particles having particle diameters of 0.5 µm or more be in a range of 50 particles/milliliter or less.

Meanwhile, a composition for forming a PT film is prepared under the same conditions as for the method of manufacturing the composition for forming a PLZT film except that the Zr compound (Zr source) and the La compound (La source) are not added.
A composition for forming a PZT film is manufactured under the same conditions as for the method of manufacturing the composition for forming a PLZT film except that the La compound (La source) is not added.
In addition, lead acetate in the manufactured composition can be an unreacted substance of the Pb compound (Pb source).

### (Method for forming a ferroelectric thin film)

A method for forming a ferroelectric thin film using the composition for forming a ferroelectric thin film prepared in the above manner will be described.
Firstly, the composition for forming a ferroelectric thin film is coated on a substrate so as to form a coated film (coating process).
Examples of a method of coating the composition on the substrate includes a spin coating method, dip coating, a liquid source misted chemical deposition (LSMCD) method, and the like. In addition, a heat-resistant substrate is used as the substrate. Examples of the heat-resistant substrate include substrates including a base material such as a Si base material and a layer laminated on the base material. Specific examples include a substrate on which a single crystal Si layer is laminated, a substrate on which a polycrystalline Si layer is laminated, a substrate on which a Pt layer is laminated, a substrate on which a Ti layer and a Pt layer (top layer) are laminated in this order, a substrate on which a SiO₂ layer, a TiO₂ layer, and a Pt layer (top layer) are laminated in in this order, a substrate on which a Ta layer and a Pt layer (top layer) are laminated in this above order, a substrate on which a Ru layer is laminated, a substrate on which a RuO₂ layer is laminated, a substrate on which a RuO₂ layer and a Ru layer (top layer) are laminated in this order, a substrate on which a Ru layer and a RuO₂ layer (top layer) are laminated in this order, a substrate on which an Ir layer is laminated, a substrate on which an IrO₂ layer is laminated, a substrate on which an IrO₂ layer and an Ir layer (top layer) are laminated in this order, a substrate on which an Ir layer and a Pt layer (top layer) are laminated in this order, a substrates on which an IrO₂ layer and a Pt layer (top layer) are laminated in this order, and a substrate on which a perovskite-type conductive oxide such as a SrRuO₃ layer, a (LaₓSr₍₁₋ₓ₎)CoO₃ layer or the like is laminated. However, the substrate is not limited thereto.

Next, the coated film formed on the substrate is heated at a temperature that is lower than the crystallization temperature of the coated film in a predetermined atmosphere so as to be dried (calcination) (drying process). Furthermore, the coated film is held at a temperature that is equal to or higher than the crystallization temperature of the coated film in a predetermined atmosphere so as to be fired (final firing) from a middle of the drying process or after completion of the drying process (firing process).
Here, the coating process and the drying process are preferably repeated a plurality of times in order to form a thick coated film (repetition process). In addition, the coated film is fired at a temperature that is equal to or higher than the crystallization temperature from a middle of the final drying process or after completion of the final drying process in the repetition process (firing process). Thereby, a thick ferroelectric thin film can be formed which has a thickness of an approximately 50 nm to 1,000 nm.

During the drying (calcination), the solvent is removed, and the organic metal compound is thermally decomposed or hydrolyzed so as to be converted into lead titanate-based perovskite or lead zirconate titanate-based complex perovskite. Therefore, the drying (calcination) is carried out in an air, an oxidization atmosphere, or a water vapor-containing atmosphere. Even during heating in the air, moisture necessary for hydrolysis is sufficiently provided from moisture in the air.
The drying (calcination) is carried out at a temperature of 150°C to 550°C for approximately 5 minutes to 10 minutes. The heating may be carried out in two steps of low-temperature heating for removing the solvent and high-temperature heating for decomposing the organic metal compound.
During the firing (final firing), the thin film obtained through the drying (calcination) is fired at a temperature that is equal to or higher than the crystallization temperature so as to be crystallized. Thereby, a ferroelectric thin film is obtained. The firing process is preferably carried out in an atmosphere consisting of one or more gases selected from O₂, N₂, Ar, N₂O, H₂, dried air, and water vapor. That is, examples of the atmosphere include an atmosphere of one gas selected from O₂, N₂, Ar, N₂O, and H₂, an atmosphere of a gas mixture of two or more selected therefrom, and dried air, and the atmospheres may include water vapor.
The firing (final firing) is carried out at a temperature of 450°C to 800°C for approximately 1 minute to 60 minutes. The firing (final firing) may be carried out through a rapid thermal annealing (RTA) thermal treatment (rapid thermal treatment). In the case where the firing (final firing) is carried out through the RTA treatment, the rate of temperature increase is preferably in a range of 10°C/s to 100°C/s.

### (Ferroelectric thin film)

The ferroelectric thin film of the embodiment is manufactured using the above-described method.
A relatively thick ferroelectric thin film is formed with no occurrence of cracking even when the composition contains lead acetate instead of lead nitrate. In addition, a thin film capacitor (ferroelectric thin film) having a high capacity and a high density is formed even when the composition does not contain Ce.

### (Complex electronic component)

The complex electronic component of the embodiment includes an element having the ferroelectric thin film as a constituent material.
The element is any one selected from thin film capacitors, capacitors, IPDs (integrated passive devices), DRAM memory capacitors, laminate capacitors, gate insulators of transistors, non-volatile memories, pyroelectric infrared detecting elements, piezoelectric elements, electro-optic elements, actuators, resonators, ultrasonic motors, surface acoustic wave elements, transducers, and LC noise filter elements.
Specifically, the ferroelectric thin film is used for a dielectric layer between electrodes in a thin film capacitor, a dielectric layer of a capacitor, a dielectric portion of an IPD, a dielectric layer of a DRAM memory capacitor, a dielectric layer of a laminate capacitor, a gate insulator of a transistor, a ferroelectric layer of a non-volatile memory, a pyroelectric layer of a pyroelectric infrared detection element, a piezoelectric layer of a piezoelectric element, a ferroelectric layer of an electro-optic element, a piezoelectric layer of an actuator, a piezoelectric layer of a resonator, a piezoelectric layer of an ultrasonic motor, a piezoelectric layer of a surface acoustic wave element, a piezoelectric layer of a transducer, and a capacitor portion of an LC noise filter element. Furthermore, among them, the ferroelectric thin film can also be used particularly for layers and portions that correspond to a frequency range of 100 MHz or more.

### EXAMPLES

Next, examples of the invention will be described in detail together with comparative examples.

### <Example 1>

Firstly, Zr tetra-n-butoxide (Zr source), Ti isopropoxide (Ti source), and acetylacetone (stabilizing agent) were fed into a reaction vessel, and the mixture was refluxed in a nitrogen atmosphere so as to obtain an organic metal compound containing Zr and Ti. Next, lead acetate trihydrate (Pb source), lanthanum acetate 1.5 hydrate (La source), and propylene glycol (solvent) were added to the organic metal compound containing Zr and Ti, and the mixture was refluxed in a nitrogen atmosphere. Then, the resultant product was distilled at a reduced pressure so as to remove byproducts. Thereby, an organic metal compound solution having a ratio of the respective metals Pb/La/Zr/Ti of 125/3/52/48 was obtained. The organic metal compound solution contained metal elements in a ratio that satisfied a composition formula (PbₓLa_{y})(Zr_{z}Ti_{(1-z)}) (x = 1.25, y = 0.03, and z = 0.52).
Next, a diluted alcohol was added to the organic metal compound solution so as to adjust the oxide-converted concentration of the organic metal compound to 10% by mass. Polyvinylpyrrolidone (weight-average molecular weight: 5,000) was added to the organic metal compound solution so as to obtain a composition 1. Here, the added amount of the polyvinylpyrrolidone was adjusted so that the ratio (percentage) of the molar number of the amount of the monomer-converted polyvinylpyrrolidone to the molar number of the total amount of Zr and Ti included in the organic metal compound solution (the molar number of PLZT molecules to be formed) became 0.1 mole%. Furthermore, the particles of byproducts were removed.
Next, a substrate was manufactured using the following method. Firstly, a Si single crystal base material having the surface of a (100) plane was prepared. The surface of the Si base material was oxidized, and a SiO₂ layer was formed in the surface of the Si base material. In addition, a TiO₂ layer and a Pt layer were deposited in this order on the SiO₂ layer. Thereby, a heat-resistant laminate substrate having a Pt layer (top layer) / TiO₂ layer / SiO₂ layer / Si base material [the surface (crystal orientation plane) of the Si base material: (100) plane] structure was manufactured.
The composition 1 was coated on the Pt layer of the substrate by a spin coating method so as to form a coated film. Next, the coated film on the substrate was heated at 350°C (a temperature that is lower than the crystallization temperature of the coated film) in air so as to be dried.
The coating process and the drying process were repeated a predetermined number of times. Subsequently, the coated film on the substrate was subjected to a rapid thermal annealing (RTA) thermal treatment in an oxygen atmosphere under conditions where an achieved temperature was 700°C (a temperature that is equal to or higher than the crystallization temperature of the coated film). Thereby, the coated film was fired, and a ferroelectric thin film having a thickness of 180 nm was manufactured on the substrate. The thin film was considered to be Example 1.

### <Examples 2 to 4>

Thin films were manufactured on substrates in the same manner as in Example 1 except that the weight-average molecular weights of the polyvinylpyrrolidone were 10,000, 50,000, and 100,000, respectively. The thin films were considered to be Examples 2, 3, and 4, respectively.

### <Examples 5 to 8>

Thin films were manufactured on substrates in the same manner as in Example 1 except that the ratio (percentage) of the molar number of the amount of the monomer-converted polyvinylpyrrolidone to the molar number of the total amount of Zr and Ti included in the composition 1 (the molar number of formed PLZT molecules) was 0.3 mole%, and the weight-average molecular weights of the polyvinylpyrrolidone were 5,000, 10,000, 50,000, and 100,000, respectively. The thin films were considered to be Examples 5, 6, 7, and 8, respectively.

### <Examples 9 to 12>

Thin films were manufactured on substrates in the same manner as in Example 1 except that the ratio (percentage) of the molar number of the amount of the monomer-converted polyvinylpyrrolidone to the molar number of the total amount of Zr and Ti included in the composition 1 (the molar number of formed PLZT molecules) was 0.5 mole%, and the weight-average molecular weights of the polyvinylpyrrolidone were 5,000, 10,000, 50,000, and 100,000, respectively. The thin films were considered to be Examples 9, 10, 11, and 12, respectively.

### <Examples 13 to 16>

Thin films were manufactured on substrates in the same manner as in Example 1 except that the ratio (percentage) of the molar number of the amount of the monomer-converted polyvinylpyrrolidone to the molar number of the total amount of Zr and Ti included in the composition 1 (the molar number of formed PLZT molecules) was 1.0 mole%, and the weight-average molecular weights of the polyvinylpyrrolidone were 5,000, 10,000, 50,000, and 100,000, respectively. The thin films were considered to be Examples 13, 14, 15, and 16, respectively.

### <Comparative example 1>

A thin film was manufactured on a substrate in the same manner as in Example 1 except that the polyvinylpyrrolidone was not added to the organic metal compound solution. The thin film was considered to be Comparative example 1.

### <Comparative examples 2 to 5>

Thin films were manufactured on substrates in the same manner as in Example 1 except that the ratio (percentage) of the molar number of the amount of the monomer-converted polyvinylpyrrolidone to the molar number of the total amount of Zr and Ti included in the composition 1 (the molar number of formed PLZT molecules) was 1.5 mole%, and the weight-average molecular weights of the polyvinylpyrrolidone were 5,000, 10,000, 50,000, and 100,000, respectively. The thin films were considered to be Comparative examples 2, 3, 4, and 5, respectively.

### <Comparative examples 6 and 7>

Thin films were manufactured on substrates in the same manner as in Example 1 except that the weight-average molecular weights of the polyvinylpyrrolidone were 3,000 and 200,000, respectively. The thin films were considered to be Comparative examples 6 and 7, respectively.

### <Comparative examples 8 and 9>

Thin films were manufactured on substrates in the same manner as in Example 1 except that the ratio (percentage) of the molar number of the amount of the monomer-converted polyvinylpyrrolidone to the molar number of the total amount of Zr and Ti included in the composition 1 (the molar number of formed PLZT molecules) was 0.3 mole%, and the weight-average molecular weights of the polyvinylpyrrolidone were 3,000 and 200,000, respectively. The thin films were considered to be Comparative examples 8 and 9, respectively.

### <Comparative examples 10 and 11>

Thin films were manufactured on substrates in the same manner as in Example 1 except that the ratio (percentage) of the molar number of the amount of the monomer-converted polyvinylpyrrolidone to the molar number of the total amount of Zr and Ti included in the composition 1 (the molar number of formed PLZT molecules) was 0.5 mole%, and the weight-average molecular weights of the polyvinylpyrrolidone were 3,000 and 200,000, respectively. The thin films were considered to be Comparative examples 10 and 11, respectively.

### <Comparative examples 12 and 13>

Thin films were manufactured on substrates in the same manner as in Example 1 except that the ratio (percentage) of the molar number of the amount of the monomer-converted polyvinylpyrrolidone to the molar number of the total amount of Zr and Ti included in the composition 1 (the molar number of formed PLZT molecules) was 1.0 mole%, and the weight-average molecular weights of the polyvinylpyrrolidone were 3,000 and 200,000, respectively. The thin films were considered to be Comparative examples 12 and 13, respectively.

### <Comparative examples 14 and 15>

Thin films were manufactured on substrates in the same manner as in Example 1 except that the ratio (percentage) of the molar number of the amount of the monomer-converted polyvinylpyrrolidone to the molar number of the total amount of Zr and Ti included in the composition 1 (the molar number of formed PLZT molecules) was 1.5 mole%, and the weight-average molecular weights of the polyvinylpyrrolidone were 3,000 and 200,000, respectively. The thin films were considered to be Comparative examples 14 and 15, respectively.

### <Comparison test 1 and evaluation>

The electrical capacity and the relative permittivity of each of the thin films of Examples 1 to 16 and Comparative examples 1 to 15 were measured. Specifically, a tetragonal Pt top electrode having dimensions of approximately 250 µmx250 µm was prepared on a substrate on which the ferroelectric thin film was formed using a metal mask by a sputtering method. The C-V characteristics (the voltage dependence of the electrical capacity) between the Pt top electrode and the Pt layer (Pt bottom electrode) located immediately below the ferroelectric thin film were evaluated in a range of -5 V to 5 V at a frequency of 1 kHz. In addition, the relative permittivity was computed from the maximum value of the measured electrical capacity.
Meanwhile, a precision LCR meter (manufactured by Hewlett-Packard Company, Precision LCR Meter 4284A) was used for measurement of the C-V characteristics. In addition, as the measurement conditions, the bias step was set to 0.1 V, the frequency of the voltage was set to 1 kHz, the oscillation level of the voltage was set to 30 mV, the delay time was set to 0.2 seconds, the temperature was set to 23°C, and the humidity was set to 50±10% (40% to 60%).
The obtained results are shown in Table 1. Meanwhile, Table 1 shows the Pb/La/Zr/Ti ratio in the composition 1, the stabilizing agents used to manufacture the composition 1, the molecular weights and the added amounts of the polyvinylpyrrolidone (PVP) included in the composition 1, and the firing atmospheres of the thin films respectively together with the electrical capacities and the relative permittivities of the thin films.

**Table 1**

| | Pb/La/Zr/Ti | Stabilizing agent | Polyvinylpyrrolidone | | Firing atmosphere | Electrical capacity (µF/cm²) | Relative permittivity |
|---|---|---|---|---|---|---|---|
| | | | Molecular weight | Added amount (mole%) | | | |
| Example 1 | 125/3/52/48 | Acetylacetone | 5000 | 0.1 | Oxygen | 8.45 | 1910 |
| Example 2 | Same as above | Same as above | 10000 | 0.1 | Same as above | 8.50 | 1920 |
| Example 3 | Same as above | Same as above | 50000 | 0.1 | Same as above | 8.50 | 1920 |
| Example 4 | Same as above | Same as above | 100000 | 0.1 | Same as above | 8.54 | 1930 |
| Example 5 | Same as above | Same as above | 5000 | 0.3 | Same as above | 9.56 | 2160 |
| Example 6 | Same as above | Same as above | 10000 | 0.3 | Same as above | 9.60 | 2170 |
| Example 7 | Same as above | Same as above | 50000 | 0.3 | Same as above | 9.60 | 2170 |
| Example 8 | Same as above | Same as above | 100000 | 0.3 | Same as above | 9.65 | 2180 |
| Example 9 | Same as above | Same as above | 5000 | 0.5 | Same as above | 9.51 | 2150 |
| Example 10 | Same as above | Same as above | 10000 | 0.5 | Same as above | 9.51 | 2150 |
| Example 11 | Same as above | Same as above | 50000 | 0.5 | Same as above | 9.56 | 2160 |
| Example 12 | Same as above | Same as above | 100000 | 0.5 | Same as above | 9.56 | 2160 |
| Example 13 | Same as above | Same as above | 5000 | 1.0 | Same as above | 8.89 | 2010 |
| Example 14 | Same as above | Same as above | 10000 | 1.0 | Same as above | 8.94 | 2020 |
| Example 15 | Same as above | Same as above | 50000 | 1.0 | Same as above | 8.94 | 2020 |
| Example 16 | Same as above | Same as above | 100000 | 1.0 | Same as above | 8.85 | 2000 |
| Comparative example 1 | 125/3/52/48 | Acetylacetone | - | - | Oxygen | 8.05 | 1820 |
| Comparative example 2 | Same as above | Same as above | 5000 | 1.5 | Same as above | 7.43 | 1680 |
| Comparative example 3 | Same as above | Same as above | 10000 | 1.5 | Same as above | 7.52 | 1700 |
| Comparative example 4 | Same as above | Same as above | 50000 | 1.5 | Same as above | 7.48 | 1690 |
| Comparative example 5 | Same as above | Same as above | 100000 | 1.5 | Same as above | 7.43 | 1680 |
| Comparative example 6 | Same as above | Same as above | 3000 | 0.1 | Same as above | 8.01 | 1810 |
| Comparative example 7 | Same as above | Same as above | 200000 | 0.1 | Same as above | 7.74 | 1750 |
| Comparative example 8 | Same as above | Same as above | 3000 | 0.3 | Same as above | 7.96 | 1800 |
| Comparative example 9 | Same as above | Same as above | 200000 | 0.3 | Same as above | 7.57 | 1710 |
| Comparative example 10 | Same as above | Same as above | 3000 | 0.5 | Same as above | 7.96 | 1800 |
| Comparative example 11 | Same as above | Same as above | 200000 | 0.5 | Same as above | 7.52 | 1700 |
| Comparative example 12 | Same as above | Same as above | 3000 | 1.0 | Same as above | 7.92 | 1790 |
| Comparative example 13 | Same as above | Same as above | 200000 | 1.0 | Same as above | 7.39 | 1670 |
| Comparative example 14 | Same as above | Same as above | 3000 | 15 | Same as above | 8.01 | 1810 |
| Comparative example 15 | Same as above | Same as above | 200000 | 1.5 | Same as above | 7.30 | 1650 |

As it is evident from Table 1, with regard to the thin film of Comparative example 1, no polyvinylpyrrolidone (PVP) was added, and the electrical capacity and the relative permittivity were 8.05 µF/cm² and 1,820 respectively which were small. With regard to the thin films of Comparative examples 2 to 5, the added amount of the PVP was 1.5 mole% (molar ratio = PVP / formed PLZT molecules =1.5/100 = 0.015) which was excessively large, the electrical capacities were in a range of 7.43 µF/cm² to 7.52 µF/cm² which were small, and the relative permittivities were in a range of 1680 to 1700 which were small.
In contrast, with regard to the thin films of Examples 1 to 16, the added amounts of the PVP were in an appropriate range of 0.1 mole% to 1.0 mole% (molar ratio = PVP /formed PLZT molecules = (0.1 to 1.0)/100 = 0.001 to 0.01), and it was found that the electrical capacities increased to 8.45 µF/cm² to 9.65 µF/cm², and the relative permittivities increased to 1,910 to 2,180, respectively.
With regard to the thin films of Comparative examples 6, 8, 10, 12, and 14, the molecular weight of the PVP was 3,000 which was small, the electrical capacities were in a range of 7.92 µF/cm² to 8.01 µF/cm² which were small, and the relative permittivities were in a range of 1,790 to 1,810 which were small, respectively. With regard to the thin films of Comparative examples 7, 9, 11, 13, and 15, the molecular weight of the PVP was 200,000 which was excessively large, the electrical capacities were in a range of 7.30 µF/cm² to 7.74 µF/cm² which were small, and the relative permittivities were in a range of 1,650 to 1,750 which were small, respectively.
In contrast, with regard to the thin films of Examples 1 to 16, the molecular weights of the PVP were in an appropriate range of 5,000 to 100,000, and it was found that the electrical capacities increased to 8.45 µF/cm² to 9.65 µF/cm² and the relative permittivities increased to 1,910 to 2,180, respectively.

### <Example 17>

Firstly, Zr tetra-n-butoxide (Zr source), Ti isopropoxide (Ti source), and diethanolamine (stabilizing agent) were fed into a reaction vessel and the mixture was refluxed in a nitrogen atmosphere so as to obtain an organic metal compound containing Zr and Ti. Next, lead acetate trihydrate (Pb source), lanthanum acetate 1.5 hydrate (La source), and propylene glycol (solvent) were added to the organic metal compound containing Zr and Ti, and the mixture was refluxed in a nitrogen atmosphere. Then, the resultant product was distilled at a reduced pressure so as to remove byproducts. Thereby, an organic metal compound solution having a ratio of the respective metals Pb/La/Zr/Ti of 125/3/52/48 was obtained. The organic metal compound solution contained metal elements in a ratio that satisfied a composition formula (PbₓLa_{y})(Zr_{z}Ti_{(1-z)}) (x = 1.25, y = 0.03, and z = 0.52).
Next, a diluted alcohol was added to the organic metal compound solution so as to adjust the oxide-converted concentration of the organic metal compound to 10% by mass. Polyvinylpyrrolidone (weight-average molecular weight: 5,000) was added to the organic metal compound solution so as to obtain a composition 2. Here, the added amount of the polyvinylpyrrolidone was adjusted so that the ratio (percentage) of the molar number of the amount of the monomer-converted polyvinylpyrrolidone to the molar number of the total amount of Zr and Ti included in the organic metal compound solution (the molar number of PLZT molecules to be formed) became 0.1 mole%. Furthermore, the particles of byproducts were removed.
Next, a substrate was manufactured using the following method. Firstly, a Si single crystal base material having the surface of a (100) plane was prepared. The surface of the Si base material was oxidized, and a SiO₂ layer was formed in the surface of the Si base material. In addition, a TiO₂ layer and a Pt layer were deposited in this order on the SiO₂ layer. Thereby, a heat-resistant laminate substrate having a Pt layer (top layer) / TiO₂ layer / SiO₂ layer / Si base material [the surface (crystal orientation plane) of the Si base material: (100) plane] structure was manufactured.
The composition 2 was coated on the Pt layer of the substrate by a spin coating method so as to form a coated film. Next, the coated film on the substrate was heated at 350°C (a temperature that is lower than the crystallization temperature of the coated film) in air so as to be dried.
The coating process and the drying process were repeated a predetermined number of times. Subsequently, the coated film on the substrate was subjected to a rapid thermal annealing (RTA) thermal treatment in dried air under conditions where an achieved temperature was 700°C (a temperature that is equal to or higher than the crystallization temperature of the coated film). Thereby, the coated film was fired, and a ferroelectric thin film having a thickness of 180 nm was manufactured on the substrate. The thin film was considered to be Example 17.

### <Examples 18 to 20>

Thin films were manufactured on substrates in the same manner as in Example 17 except that the weight-average molecular weights of the polyvinylpyrrolidone were 10,000, 50,000, and 100,000, respectively. The thin films were considered to be Examples 18, 19, and 20, respectively.

### <Examples 21 to 24>

Thin films were manufactured on substrates in the same manner as in Example 17 except that the ratio (percentage) of the molar number of the amount of the monomer-converted polyvinylpyrrolidone to the molar number of the total amount of Zr and Ti included in the composition 2 (the molar number of formed PLZT molecules) was 0.3 mole%, and the weight-average molecular weights of the polyvinylpyrrolidone were 5,000, 10,000, 50,000, and 100,000, respectively. The thin films were considered to be Examples 21, 22, 23, and 24, respectively.

### <Examples 25 to 28>

Thin films were manufactured on substrates in the same manner as in Example 17 except that the ratio (percentage) of the molar number of the amount of the monomer-converted polyvinylpyrrolidone to the molar number of the total amount of Zr and Ti included in the composition 2 (the molar number of formed PLZT molecules) was 0.5 mole%, and the weight-average molecular weights of the polyvinylpyrrolidone were 5,000, 10,000, 50,000, and 100,000, respectively. The thin films were considered to be Examples 25, 26, 27, and 28, respectively.

### <Examples 29 to 32>

Thin films were manufactured on substrates in the same manner as in Example 17 except that the ratio (percentage) of the molar number of the amount of the monomer-converted polyvinylpyrrolidone to the molar number of the total amount of Zr and Ti included in the composition 2 (the molar number of formed PLZT molecules) was 1.0 mole%, and the weight-average molecular weights of the polyvinylpyrrolidone were 5,000, 10,000, 50,000, and 100,000, respectively. The thin films were considered to be Examples 29, 30, 31, and 32, respectively.

### <Comparative example 16>

A thin film was manufactured on a substrate in the same manner as in Example 17 except that the polyvinylpyrrolidone was not added to the organic metal compound solution. The thin film was considered to be Comparative example 16.

### <Comparative examples 17 to 20>

Thin films were manufactured on substrates in the same manner as in Example 17 except that the ratio (percentage) of the molar number of the amount of the monomer-converted polyvinylpyrrolidone to the molar number of the total amount of Zr and Ti included in the composition 2 (the molar number of formed PLZT molecules) was 1.5 mole%, and the weight-average molecular weights of the polyvinylpyrrolidone were 5,000, 10,000, 50,000, and 100,000, respectively. The thin films were considered to be Comparative examples 17, 18, 19, and 20, respectively.

### <Comparative examples 21 and 22>

Thin films were manufactured on substrates in the same manner as in Example 17 except that the weight-average molecular weights of the polyvinylpyrrolidone were 3,000 and 200,000, respectively. The thin films were considered to be Comparative examples 21 and 22 respectively.

### <Comparative examples 23 and 24>

Thin films were manufactured on substrates in the same manner as in Example 17 except that the ratio (percentage) of the molar number of the amount of the monomer-converted polyvinylpyrrolidone to the molar number of the total amount of Zr and Ti included in the composition 2 (the molar number of formed PLZT molecules) was 0.3 mole%, and the weight-average molecular weights of the polyvinylpyrrolidone were 3,000 and 200,000, respectively. The thin films were considered to be Comparative examples 23 and 24 respectively.

### <Comparative examples 25 and 26>

Thin films were manufactured on substrates in the same manner as in Example 17 except that the ratio (percentage) of the molar number of the amount of the monomer-converted polyvinylpyrrolidone to the molar number of the total amount of Zr and Ti included in the composition 2 (the molar number of formed PLZT molecules) was 0.5 mole%, and the weight-average molecular weights of the polyvinylpyrrolidone were 3,000 and 200,000, respectively. The thin films were considered to be Comparative examples 25 and 26 respectively.

### <Comparative examples 27 and 28>

Thin films were manufactured on substrates in the same manner as in Example 17 except that the ratio (percentage) of the molar number of the amount of the monomer-converted polyvinylpyrrolidone to the molar number of the total amount of Zr and Ti included in the composition 2 (the molar number of formed PLZT molecules) was 1.0 mole%, and the weight-average molecular weights of the polyvinylpyrrolidone were 3,000 and 200,000, respectively. The thin films were considered to be Comparative examples 27 and 28 respectively.

### <Comparative examples 29 and 30>

Thin films were manufactured on substrates in the same manner as in Example 17 except that the ratio (percentage) of the molar number of the amount of the monomer-converted polyvinylpyrrolidone to the molar number of the total amount of Zr and Ti included in the composition 2 (the molar number of formed PLZT molecules) was 1.5 mole%, and the weight-average molecular weights of the polyvinylpyrrolidone were 3,000 and 200,000, respectively. The thin films were considered to be Comparative examples 29 and 30 respectively.

### <Comparison test 2 and evaluation>

The electrical capacity and the relative permittivity of each of the thin films of Examples 17 to 32 and Comparative examples 16 to 30 were measured. Specific measurements of the electrical capacity and the relative permittivity of the ferroelectric thin film were carried out by the same methods as in the comparison test 1.
The obtained results are shown in Table 2. Meanwhile, Table 2 shows the Pb/La/Zr/Ti ratio in the composition 2, the stabilizing agents used to manufacture the composition 2, the molecular weights and the added amounts of the polyvinylpyrrolidone (PVP) included in the composition 2, and the firing atmospheres of the thin films respectively together with the electrical capacities and the relative permittivities of the thin films.

**Table 2**

| | Pb/La/Zr/Ti | Stabilizing agent | Polyvinylpyrrolidone | | Firing atmosphere | Electrical capacity (µF/cm²) | Relative permittivity |
|---|---|---|---|---|---|---|---|
| | | | Molecular weight | Added amount (mole%) | | | |
| Example 17 | 125/3/52/48 | Diethanolamine | 5000 | 0.1 | Dried air | 8.41 | 1900 |
| Example 18 | Same as above | Same as above | 10000 | 0.1 | Same as above | 8.50 | 1920 |
| Example 19 | Same as above | Same as above | 50000 | 0.1 | Same as above | 8.50 | 1920 |
| Example 20 | Same as above | Same as above | 100000 | 0.1 | Same as above | 8.45 | 1910 |
| Example 21 | Same as above | Same as above | 5000 | 0.3 | Same as above | 9.65 | 2180 |
| Example 22 | Same as above | Same as above | 10000 | 0.3 | Same as above | 9.60 | 2170 |
| Example 23 | Same as above | Same as above | 50000 | 0.3 | Same as above | 9.65 | 2180 |
| Examples 24 | Same as above | Same as above | 100000 | 0.3 | Same as above | 9.56 | 2160 |
| Example 25 | Same as above | Same as above | 5000 | 0.5 | Same as above | 9.51 | 2150 |
| Example 26 | Same as above | Same as above | 10000 | 0.5 | Same as above | 9.47 | 2140 |
| Example 27 | Same as above | Same as above | 50000 | 0.5 | Same as abode | 9.47 | 2140 |
| Example 28 | Same as above | Same as above | 100000 | 0.5 | Same as above | 9.47 | 2140 |
| Example 29 | Same as above | Same as above | 5000 | 1.0 | Same as above | 8.81 | 1990 |
| Example 30 | Same as above | Same as above | 10000 | 1.0 | Same as above | 8.85 | 2000 |
| Example 31 | Same as above | Same as above | 50000 | 1.0 | Same as above | 8.85 | 2000 |
| Example 32 | Same as above | Same as above | 100000 | 1.0 | Same as above | 8.89 | 2010 |
| Comparative example 16 | 125/3/52/48 | Diethanolamine | - | - | Dried air | 8.01 | 1810 |
| Comparative example 17 | Same as above | Same as above | 5000 | 1.5 | Same as above | 7.39 | 1670 |
| Comparative example 18 | Same as above | Same as above | 10000 | 1.5 | Same as above | 7.57 | 1710 |
| Comparative example 19 | Same as above | Same as above | 50000 | 1.5 | Same as above | 7.39 | 1670 |
| Comparative example 20 | Same as above | Same as above | 100000 | 1.5 | Same as above | 7.48 | 1690 |
| Comparative example 21 | Same as above | Same as above | 3000 | 0.1 | Same as above | 7.43 | 1680 |
| Comparative example 22 | Same as above | Same as above | 200000 | 0.1 | Same as above | 7.92 | 1790 |
| Comparative example 23 | Same as above | Same as above | 3000 | 0.3 | Same as above | 8.01 | 1810 |
| Comparative example 24 | Same as above | Same as above | 200000 | 0.3 | Same as above | 7.52 | 1700 |
| Comparative example 25 | Same as above | Same as above | 3000 | 0.5 | Same as above | 8.05 | 1820 |
| Comparative example 26 | Same as above | Same as above | 200000 | 0.5 | Same as above | 7.48 | 1690 |
| Comparative example 27 | Same as above | Same as above | 3000 | 1.0 | Same as above | 7.96 | 1800 |
| Comparative example 28 | Same as above | Same as above | 200000 | 1.0 | Same as above | 7.43 | 1680 |
| Comparative example 29 | Same as above | Same as above | 3000 | 1.5 | Same as above | 7.96 | 1800 |
| Comparative example 30 | Same as above | Same as above | 200000 | 1.5 | Same as above | 7.39 | 1670 |

As it is evident from Table 2, with regard to the thin film of Comparative example 16, no polyvinylpyrrolidone (PVP) was added, and the electrical capacity and the relative permittivity were 8.01 µF/cm² and 1,810 respectively which were small. With regard to the thin films of Comparative examples 17 to 20, the added amount of the PVP was 1.5 mole% (molar ratio = PVP/formed PLZT molecules = 1.5/100 = 0.015) which was excessively large, the electrical capacities were in a range of 7.39 µF/cm² to 7.57 µF/cm² which were small, and the relative permittivities were in a range of 1,670 to 1,710 which were small.
In contrast, with regard to the thin films of Examples 17 to 32, the added amounts of the PVP were in an appropriate range of 0.1 mole% to 1.0 mole% (molar ratio = PVP/formed PLZT molecules = (0.1 to 1.0)/100 = 0.001 to 0.01), and it was found that the electrical capacities increased to 8.41 µF/cm² to 9.65 µF/cm², and the relative permittivities increased to 1,900 to 2,180, respectively.
With regard to the thin films of Comparative examples 21, 23, 25, 27, and 29, the molecular weight of the PVP was 3,000 which was small, the electrical capacities were in a range of 7.43 µF/cm² to 8.05 µF/cm² which were small, and the relative permittivities were in a range of 1,680 to 1,820 which were small, respectively. With regard to the thin films of Comparative examples 22, 24, 26, 28, and 30, the molecular weight of the PVP was 200,000 which was excessively large, the electrical capacities were in a range of 7.39 µF/cm² to 7.92 µF/cm² which were small, and the relative permittivities were in a range of 1,670 to 1,790 which were small, respectively.
In contrast, with regard to the thin films of Examples 17 to 32, the molecular weights of the PVP were in an appropriate range of 5,000 to 100,000, and it was found that the electrical capacities increased to 8.41 µF/cm² to 9.65 µF/cm² and the relative permittivities increased to 1,900 to 2,180, respectively.

### <Example 33>

Firstly, Zr tetra-n-butoxide (Zr source), Ti isopropoxide (Ti source), and acetylacetone (stabilizing agent) were fed into a reaction vessel and the mixture was refluxed in a nitrogen atmosphere so as to obtain an organic metal compound containing Zr and Ti. Next, lead acetate trihydrate (Pb source) and propylene glycol (solvent) were added to the organic metal compound containing Zr and Ti, and the mixture was refluxed in a nitrogen atmosphere. Then, the resultant product was distilled at a reduced pressure so as to remove byproducts. Thereby, an organic metal compound solution having a ratio of the respective metals Pb/La/Zr/Ti of 125/0/52/48 was obtained. The organic metal compound solution contained metal elements in a ratio that satisfied a composition formula (PbₓLa_{y})(Zr_{z}Ti_{(1-z)}) (x = 1.25, y = 0, and z = 0.52).
Next, a diluted alcohol was added to the organic metal compound solution so as to adjust the oxide-converted concentration of the organic metal compound to 10% by mass. Polyvinylpyrrolidone (weight-average molecular weight: 5,000) was added to the organic metal compound solution so as to obtain a composition 3. Here, the added amount of the polyvinylpyrrolidone was adjusted so that the ratio (percentage) of the molar number of the amount of the monomer-converted polyvinylpyrrolidone to the molar number of the total amount of Zr and Ti included in the organic metal compound solution (the molar number of PZT molecules to be formed) became 0.1 mole%. Furthermore, the particles of byproducts were removed.
Next, a substrate was manufactured using the following method. Firstly, a Si single crystal base material having the surface of a (100) plane was prepared. The surface of the Si base material was oxidized, and a SiO₂ layer was formed in the surface of the Si base material. In addition, a TiO₂ layer and a Pt layer were deposited in this order on the SiO₂ layer. Thereby, a heat-resistant laminate substrate having a Pt layer (top layer) / TiO₂ layer / SiO₂ layer / Si base material [the surface (crystal orientation plane) of the Si base material: (100) plane] structure was manufactured.
The composition 3 was coated on the Pt layer of the substrate by a spin coating method so as to form a coated film. Next, the coated film on the substrate was heated at 350°C (a temperature that is lower than the crystallization temperature of the coated film) in air so as to be dried.
The coating process and the drying process were repeated a predetermined number of times. Subsequently, the coated film on the substrate was subjected to a rapid thermal annealing (RTA) thermal treatment in an oxygen atmosphere under conditions where an achieved temperature was 700°C (a temperature that is equal to or higher than the crystallization temperature of the coated film). Thereby, the coated film was fired, and a ferroelectric thin film having a thickness of 180 nm was manufactured on the substrate. The thin film was considered to be Example 33.

### <Examples 34 to 36>

Thin films were manufactured on substrates in the same manner as in Example 33 except that the weight-average molecular weights of the polyvinylpyrrolidone were 10,000, 50,000, and 100,000, respectively. The thin films were considered to be Examples 34, 35, and 36, respectively.

### <Examples 37 to 40>

Thin films were manufactured on substrates in the same manner as in Example 33 except that the ratio (percentage) of the molar number of the amount of the monomer-converted polyvinylpyrrolidone to the molar number of the total amount of Zr and Ti included in the composition 3 (the molar number of formed PZT molecules) was 0.3 mole%, and the weight-average molecular weights of the polyvinylpyrrolidone were 5,000, 10,000, 50,000, and 100,000, respectively. The thin films were considered to be Examples 37, 38, 39, and 40 respectively.

### <Examples 41 to 44>

Thin films were manufactured on substrates in the same manner as in Example 33 except that the ratio (percentage) of the molar number of the amount of the monomer-converted polyvinylpyrrolidone to the molar number of the total amount of Zr and Ti included in the composition 3 (the molar number of formed PZT molecules) was 0.5 mole%, and the weight-average molecular weights of the polyvinylpyrrolidone were 5,000, 10,000, 50,000, and 100,000, respectively. The thin films were considered to be Examples 41, 42, 43, and 44 respectively.

### <Examples 45 to 48>

Thin films were manufactured on substrates in the same manner as in Example 33 except that the ratio (percentage) of the molar number of the amount of the monomer-converted polyvinylpyrrolidone to the molar number of the total amount of Zr and Ti included in the composition 3 (the molar number of formed PZT molecules) was 1.0 mole%, and the weight-average molecular weights of the polyvinylpyrrolidone were 5,000, 10,000, 50,000, and 100,000, respectively. The thin films were considered to be Examples 45, 46, 47, and 48 respectively.

### <Comparative example 31>

A thin film was manufactured on a substrate in the same manner as in Example 33 except that the polyvinylpyrrolidone was not added to the organic metal compound solution. The thin film was considered to be Comparative example 31.

### <Comparative examples 32 to 35>

Thin films were manufactured on substrates in the same manner as in Example 33 except that the ratio (percentage) of the molar number of the amount of the monomer-converted polyvinylpyrrolidone to the molar number of the total amount of Zr and Ti included in the composition 3 (the molar number of formed PZT molecules) was 1.5 mole%, and the weight-average molecular weights of the polyvinylpyrrolidone were 5,000, 10,000, 50,000, and 100,000, respectively. The thin films were considered to be Comparative examples 32, 33, 34, and 35 respectively.

### <Comparative examples 36 and 37>

Thin films were manufactured on substrates in the same manner as in Example 33 except that the weight-average molecular weights of the polyvinylpyrrolidone were 3,000 and 200,000, respectively. The thin films were considered to be Comparative examples 36 and 37, respectively.

### <Comparative examples 38 and 39>

Thin films were manufactured on substrates in the same manner as in Example 33 except that the ratio (percentage) of the molar number of the amount of the monomer-converted polyvinylpyrrolidone to the molar number of the total amount of Zr and Ti included in the composition 3 (the molar number of formed PZT molecules) was 0.3 mole%, and the weight-average molecular weights of the polyvinylpyrrolidone were 3,000 and 200,000, respectively. The thin films were considered to be Comparative examples 38 and 39, respectively.

### <Comparative examples 40 and 41>

Thin films were manufactured on substrates in the same manner as in Example 33 except that the ratio (percentage) of the molar number of the amount of the monomer-converted polyvinylpyrrolidone to the molar number of the total amount of Zr and Ti included in the composition 3 (the molar number of formed PZT molecules) was 0.5 mole%, and the weight-average molecular weights of the polyvinylpyrrolidone were 3,000 and 200,000, respectively. The thin films were considered to be Comparative examples 40 and 41 respectively.

### <Comparative examples 42 and 43>

Thin films were manufactured on substrates in the same manner as in Example 33 except that the ratio (percentage) of the molar number of the amount of the monomer-converted polyvinylpyrrolidone to the molar number of the total amount of Zr and Ti included in the composition 3 (the molar number of formed PZT molecules) was 1.0 mole%, and the weight-average molecular weights of the polyvinylpyrrolidone were 3,000 and 200,000, respectively. The thin films were considered to be Comparative examples 42 and 43 respectively.

### <Comparative examples 44 and 45>

Thin films were manufactured on substrates in the same manner as in Example 33 except that the ratio (percentage) of the molar number of the amount of the monomer-converted polyvinylpyrrolidone to the molar number of the total amount of Zr and Ti included in the composition 3 (the molar number of formed PZT molecules) was 1.5 mole%, and the weight-average molecular weights of the polyvinylpyrrolidone were 3,000 and 200,000, respectively. The thin films were considered to be Comparative examples 44 and 45 respectively.

### <Comparison test 3 and evaluation>

The electrical capacity and the relative permittivity of each of the thin films of Examples 33 to 48 and Comparative examples 31 to 45 were measured respectively. Specific measurements of the electrical capacity and the relative permittivity of the ferroelectric thin film were carried out by the same methods as in the comparison test 1.
The obtained results are shown in Table 3. Meanwhile, Table 3 shows the Pb/La/Zr/Ti ratio in the composition 3, the stabilizing agents used to manufacture the composition 3, the molecular weights and the added amounts of the polyvinylpyrrolidone (PVP) included in the composition 3, and the firing atmospheres of the thin films respectively together with the electrical capacities and the relative permittivities of the thin films.

**Table 3**

| | Pb/La/Zr/Ti | Stabilizing agent | Polyvinylpyrrolidone | | Firing atmosphere | Electrical capacity (µF/cm²) | Relative permittivity |
|---|---|---|---|---|---|---|---|
| | | | Molecular weight | Added amount (mole%) | | | |
| Example 33 | 125/0/52/48 | Acetylacetone | 5000 | 0.1 | Oxygen | 7.83 | 1770 |
| Example 34 | Same as above | Same as above | 10000 | 0.1 | Same as above | 7.88 | 1780 |
| Example 35 | Same as above | Same as above | 50000 | 0.1 | Same as above | 7.83 | 1770 |
| Example 36 | Same as above | Same as above | 100000 | 0.1 | Same as above | 7.79 | 1760 |
| Example 37 | Same as above | Same as above | 5000 | 0.3 | Same as above | 8.81 | 1990 |
| Example 38 | Same as above | Same as above | 10000 | 0.3 | Same as above | 8.89 | 2010 |
| Example 39 | Same as above | Same as above | 50000 | 0.3 | Same as above | 8.85 | 2000 |
| Example 40 | Same as above | Same as above | 100000 | 0.3 | Same as above | 8.85 | 2000 |
| Example 41 | Same as above | Same as above | 5000 | 0.5 | Same as above | 8.98 | 2030 |
| Example 42 | Same as above | Same as above | 10000 | 0.5 | Same as above | 8.94 | 2020 |
| Example 43 | Same as above | Same as above | 50000 | 0.5 | Same as above | 8.94 | 2020 |
| Example 44 | Same as above | Same as above | 100000 | 0.5 | Same as above | 8.89 | 2010 |
| Example 45 | Same as above | Same as above | 5000 | 1.0 | Same as above | 8.01 | 1810 |
| Example 46 | Same as above | Same as above | 10000 | 1.0 | Same as above | 8.05 | 1820 |
| Example 47 | Same as above | Same as above | 50000 | 1.0 | Same as above | 8.05 | 1820 |
| Example 48 | Same as above | Same as above | 100000 | 1.0 | Same as above | 7.96 | 1800 |
| Comparative example 31 | 125/0/52/48 | Acetylacetone | - | - | Oxygen | 7.35 | 1660 |
| Comparative example 32 | Same as above | Same as above | 5000 | 1.5 | Same as above | 6.81 | 1540 |
| Comparative example 33 | Same as above | Same as above | 10000 | 1.5 | Same as above | 6.73 | 1520 |
| Comparative example | Same as above | Same as above | 50000 | 1.5 | Same as above | 6.73 | 1520 |
| Comparative example 35 | Same as above | Same as above | 100000 | 1.5 | Same as above | 6.77 | 1530 |
| Comparative example 36 | Same as above | Same as above | 3000 | 0.1 | Same as above | 7.30 | 1650 |
| Comparative example 37 | Same as above | Same as above | 200000 | 0.1 | Same as above | 7.26 | 1640 |
| Comparative example 38 | Same as above | Same as above | 3000 | 0.3 | Same as above | 7.26 | 1640 |
| Comparative example 39 | Same as above | Same as above | 200000 | 0.3 | Same as above | 7.21 | 1630 |
| Comparative example 40 | Same as above | Same as above | 3000 | 0.5 | Same as above | 7.21 | 1630 |
| Comparative example 41 | Same as above | Same as above | 200000 | 0.5 | Same as above | 7.12 | 1610 |
| Comparative example 42 | Same as above | Same as above | 3000 | 1.0 | Same as above | 7.21 | 1630 |
| Comparative example 43 | Same as above | Same as above | 200000 | 1.0 | Same as above | 6.77 | 1530 |
| Comparative example 44 | Same as above | Same as above | 3000 | 1.5 | Same as above | 7.17 | 1620 |
| Comparative example 45 | Same as above | Same as above | 200000 | 1.5 | Same as above | 6.68 | 1510 |

As it is evident from Table 3, with regard to the thin film of Comparative example 31, no polyvinylpyrrolidone (PVP) was added, and the electrical capacity and the relative permittivity were 7.35 µF/cm² and 1,660 respectively which were small. With regard to the thin films of Comparative examples 32 to 35, the added amount of the PVP was 1.5 mole% (molar ratio = PVP/formed PZT molecules = 1.5/100 = 0.015) which was excessively large, the electrical capacities were in a range of 6.73 µF/cm² to 6.81 µF/cm² which were small, and the relative permittivities were in a range of 1,520 to 1,540 which were small.
In contrast, with regard to the thin films of Examples 33 to 48, the added amounts of the PVP were in an appropriate range of 0.1 mole% to 1.0 mole% (molar ratio = PVP/formed PZT molecules = (0.1 to 1.0)/100 = 0.001 to 0.01), and it was found that the electrical capacities increased to 7.79 µF/cm² to 8.98 µF/cm² and the relative permittivities increased to 1,760 to 2,030, respectively.
With regard to the thin films of Comparative examples 36, 38, 40, 42, and 44, the molecular weight of the PVP was 3,000 which was small, the electrical capacities were in a range of 7.17 µF/cm² to 7.30 µF/cm² which were small, and the relative permittivities were in a range of 1,620 to 1,650 which were small, respectively. With regard to the thin films of Comparative examples 37, 39, 41, 43, and 45, the molecular weight of the PVP was 200,000 which was excessively large, the electrical capacities were in a range of 6.68 µF/cm² to 7.26 µF/cm² which were small, and the relative permittivities were in a range of 1,510 to 1,640 which were small, respectively.
In contrast, with regard to the thin films of Examples 33 to 48, the molecular weights of the PVP were in an appropriate range of 5,000 to 100,000, and it was found that the electrical capacities increased to 7.79 µF/cm² to 8.98 µF/cm² and the relative permittivities increased to 1,760 to 2,030, respectively.

### <Example 49>

Firstly, Zr tetra-n-butoxide (Zr source), Ti isopropoxide (Ti source), and diethanolamine (stabilizing agent) were fed into a reaction vessel and the mixture was refluxed in a nitrogen atmosphere so as to obtain an organic metal compound containing Zr and Ti. Next, lead acetate trihydrate (Pb source) and propylene glycol (solvent) were added to the organic metal compound containing Zr and Ti, and the mixture was refluxed in a nitrogen atmosphere. Then, the resultant product was distilled at a reduced pressure so as to remove byproducts. Thereby, an organic metal compound solution having a ratio of the respective metals Pb/La/Zr/Ti of 125/0/52/48 was obtained. The organic metal compound solution contains metal elements in a ratio that satisfies a composition formula (PbₓLa_{y})(Zr_{z}Ti_{(1-z)}) (x = 1.25, y = 0, and z = 0.52).
Next, a diluted alcohol was added to the organic metal compound solution so as to adjust the oxide-converted concentration of the organic metal compound to 10% by mass. Polyvinylpyrrolidone (weight-average molecular weight: 5,000) was added to the organic metal compound solution so as to obtain a composition 4. Here, the added amount of the polyvinylpyrrolidone was adjusted so that the ratio (percentage) of the molar number of the amount of the monomer-converted polyvinylpyrrolidone to the molar number of the total amount of Zr and Ti included in the organic metal compound solution (the molar number of PZT molecules to be formed) became 0.1 mole%. Furthermore, the particles of byproducts were removed.
Next, a substrate was manufactured using the following method. Firstly, a Si single crystal base material having the surface of a (100) plane was prepared. The surface of the Si base material was oxidized, and a SiO₂ layer was formed in the surface of the Si base material. In addition, a TiO₂ layer and a Pt layer were deposited in this order on the SiO₂ layer. Thereby, a heat-resistant laminate substrate having a Pt layer (top layer) / TiO₂ layer / SiO₂ layer / Si base material [the surface (crystal orientation plane) of the Si base material: (100) plane] structure was manufactured.
The composition 4 was coated on the Pt layer of the substrate by a spin coating method so as to form a coated film. Next, the coated film on the substrate was heated at 350°C (a temperature that is lower than the crystallization temperature of the coated film) in air so as to be dried.
The coating process and the drying process were repeated a predetermined number of times. Subsequently, the coated film on the substrate was subjected to a rapid thermal annealing (RTA) thermal treatment in dried air under conditions where an achieved temperature was 700°C (a temperature that is equal to or higher than the crystallization temperature of the coated film). Thereby, the coated film was fired, and a ferroelectric thin film having a thickness of 180 nm was manufactured on the substrate. The thin film was considered to be Example 49.

### <Examples 50 to 52>

Thin films were manufactured on substrates in the same manner as in Example 49 except that the weight-average molecular weights of the polyvinylpyrrolidone were 10,000, 50,000, and 100,000, respectively. The thin films were considered to be Examples 50, 51, and 52 respectively.

### <Examples 53 to 56>

Thin films were manufactured on substrates in the same manner as in Example 49 except that the ratio (percentage) of the molar number of the amount of the monomer-converted polyvinylpyrrolidone to the molar number of the total amount of Zr and Ti included in the composition 4 (the molar number of formed PZT molecules) was 0.3 mole%, and the weight-average molecular weights of the polyvinylpyrrolidone were 5,000, 10,000, 50,000, and 100,000, respectively. The thin films were considered to be Examples 53, 54, 55, and 56, respectively.

### <Examples 57 to 60>

Thin films were manufactured on substrates in the same manner as in Example 49 except that the ratio (percentage) of the molar number of the amount of the monomer-converted polyvinylpyrrolidone to the molar number of the total amount of Zr and Ti included in the composition 4 (the molar number of formed PZT molecules) was 0.5 mole%, and the weight-average molecular weights of the polyvinylpyrrolidone were 5,000, 10,000, 50,000, and 100,000, respectively. The thin films were considered to be Examples 57, 58, 59, and 60, respectively.

### <Examples 61 to 64>

Thin films were manufactured on substrates in the same manner as in Example 49 except that the ratio (percentage) of the molar number of the amount of the monomer-converted polyvinylpyrrolidone to the molar number of the total amount of Zr and Ti included in the composition 4 (the molar number of formed PZT molecules) was 1.0 mole%, and the weight-average molecular weights of the polyvinylpyrrolidone were 5,000, 10,000, 50,000, and 100,000, respectively. The thin films were considered to be Examples 61, 62, 63, and 64, respectively.

### <Comparative example 46>

A thin film was manufactured on a substrate in the same manner as in Example 49 except that the polyvinylpyrrolidone was not added to the organic metal compound solution. The thin film was considered to be Comparative example 46.

### <Comparative examples 47 to 50>

Thin films were manufactured on substrates in the same manner as in Example 49 except that the ratio (percentage) of the molar number of the amount of the monomer-converted polyvinylpyrrolidone to the molar number of the total amount of Zr and Ti included in the composition 4 (the molar number of formed PZT molecules) was 1.5 mole%, and the weight-average molecular weights of the polyvinylpyrrolidone were 5,000, 10,000, 50,000, and 100,000, respectively. The thin films were considered to be Comparative examples 47, 48, 49, and 50, respectively.

### <Comparative examples 51 and 52>

Thin films were manufactured on substrates in the same manner as in Example 49 except that the weight-average molecular weights of the polyvinylpyrrolidone were 3,000 and 200,000, respectively. The thin films were considered to be Comparative examples 51 and 52, respectively.

### <Comparative examples 53 and 54>

Thin films were manufactured on substrates in the same manner as in Example 49 except that the ratio (percentage) of the molar number of the amount of the monomer-converted polyvinylpyrrolidone to the molar number of the total amount of Zr and Ti included in the composition 4 (the molar number of formed PZT molecules) was 0.3 mole%, and the weight-average molecular weights of the polyvinylpyrrolidone were 3,000 and 200,000, respectively. The thin films were considered to be Comparative examples 53 and 54, respectively.

### <Comparative examples 55 and 56>

Thin films were manufactured on substrates in the same manner as in Example 49 except that the ratio (percentage) of the molar number of the amount of the monomer-converted polyvinylpyrrolidone to the molar number of the total amount of Zr and Ti included in the composition 4 (the molar number of formed PZT molecules) was 0.5 mole%, and the weight-average molecular weights of the polyvinylpyrrolidone were 3,000 and 200,000, respectively. The thin films were considered to be Comparative examples 55 and 56, respectively.

### <Comparative examples 57 and 58>

Thin films were manufactured on substrates in the same manner as in Example 49 except that the ratio (percentage) of the molar number of the amount of the monomer-converted polyvinylpyrrolidone to the molar number of the total amount of Zr and Ti included in the composition 4 (the molar number of formed PZT molecules) was 1.0 mole%, and the weight-average molecular weights of the polyvinylpyrrolidone were 3,000 and 200,000, respectively. The thin films were considered to be Comparative examples 57 and 58, respectively.

### <Comparative examples 59 and 60>

Thin films were manufactured on substrates in the same manner as in Example 49 except that the ratio (percentage) of the molar number of the amount of the monomer-converted polyvinylpyrrolidone to the molar number of the total amount of Zr and Ti included in the composition 4 (the molar number of formed PZT molecules) was 1.5 mole%, and the weight-average molecular weights of the polyvinylpyrrolidone were 3,000 and 200,000, respectively. The thin films were considered to be Comparative examples 59 and 60, respectively.

### <Comparison test 3 and evaluation>

The electrical capacity and the relative permittivity of each of the thin films of Examples 49 to 64 and Comparative examples 46 to 60 were measured. Specific measurements of the electrical capacity and the relative permittivity of the ferroelectric thin film were carried out by the same methods as in the comparison test 1.
The obtained results are shown in Table 4. Meanwhile, Table 4 shows the Pb/La/Zr/Ti ratio in the composition 4, the stabilizing agents used to manufacture the composition 4, the molecular weights and the added amounts of the polyvinylpyrrolidone (PVP) included in the composition 4, and the firing atmospheres of the thin films respectively together with the electrical capacities and the relative permittivities of the thin films.

**Table 4**

| | Pb/La/Zr/Ti | Stabilizing agent | Polyvinylpyrrolidone | | Firing atmosphere | Electrical capacity (µF/cm²) | Relative permittivity |
|---|---|---|---|---|---|---|---|
| | | | Molecular weight | Added amount (mole%) | | | |
| Example 49 | 125/0/52/48 | Diethanolamine | 5000 | 0.1 | Dried air | 7.79 | 1760 |
| Example 50 | Same as above | Same as above | 10000 | 0.1 | Same as above | 7.79 | 1760 |
| Example 51 | Same as above | Same as above | 50000 | 0.1 | Same as above | 7.74 | 1750 |
| Example 52 | Same as above | Same as above | 100000 | 0.1 | Same as above | 7.70 | 1740 |
| Example 53 | Same as above | Same as above | 5000 | 0.3 | Same as above | 8.85 | 2000 |
| Example 54 | Same as above | Same as above | 10000 | 0.3 | Same as above | 8.85 | 2000 |
| Example 55 | Same as above | Same as above | 50000 | 0.3 | Same as above | 8.76 | 1980 |
| Example 56 | Same as above | Same as above | 100000 | 0.3 | Same as above | 8.89 | 2010 |
| Example 57 | Same as above | Same as above | 5000 | 0.5 | Same as above | 8.89 | 2010 |
| Example 58 | Same as above | Same as above | 10000 | 0.5 | Same as above | 8.94 | 2020 |
| Example 59 | Same as above | Same as above | 50000 | 0.5 | Same as above | 8.85 | 2000 |
| Example 60 | Same as above | Same as above | 100000 | 0.5 | Same as above | 8.85 | 2000 |
| Example 61 | Same as above | Same as above | 5000 | 1.0 | Same as above | 8.01 | 1810 |
| Example 62 | Same as above | Same as above | 10000 | 1.0 | Same as above | 7.96 | 1800 |
| Example 63 | Same as above | Same as above | 50000 | 1.0 | Same as above | 7.96 | 1800 |
| Example 64 | Same as above | Same as above | 100000 | 1.0 | Same as above | 8.01 | 1810 |
| Comparative example 46 | 125/0/52/48 | Diethanolamine | - | - | Dried air | 7.30 | 1650 |
| Comparative example 47 | Same as above | Same as above | 5000 | 1.5 | Same as above | 6.86 | 1550 |
| Comparative example 48 | Same as above | Same as above | 10000 | 1.5 | Same as above | 6.73 | 1520 |
| Comparative example 49 | Same as above | Same as above | 50000 | 1.5 | Same as above | 6.77 | 1530 |
| Comparative example 50 | Same as above | Same as above | 100000 | 1.5 | Same as above | 6.77 | 1530 |
| Comparative example 51 | Same as above | Same as above | 3000 | 0.1 | Same as above | 7.21 | 1630 |
| Comparative example 52 | Same as above | Same as above | 200000 | 0.1 | Same as above | 7.21 | 1630 |
| Comparative example 53 | Same as above | Same as above | 3000 | 0.3 | Same as above | 7.26 | 1640 |
| Comparative example 54 | Same as above | Same as above | 200000 | 0.3 | Same as above | 7.17 | 1620 |
| Comparative example 55 | Same as above | Same as above | 3000 | 0.5 | Same as above | 7.21 | 1630 |
| Com arative example 56 | Same as above | Same as above | 200000 | 0.5 | Same as above | 7.04 | 1590 |
| Comparative example 57 | Same as above | Same as above | 3000 | 1.0 | Same as above | 7.21 | 1630 |
| Comparative example 58 | Same as above | Same as above | 200000 | 1.0 | Same as above | 6.73 | 1520 |
| Comparative example 59 | Same as above | Same as above | 3000 | 1.5 | Same as above | 7.17 | 1620 |
| Comparative example 60 | Same as above | Same as above | 200000 | 1.5 | Same as above | 6.64 | 1500 |

As it is evident from Table 4, with regard to the thin film of Comparative example 46, no polyvinylpyrrolidone (PVP) was added, and the electrical capacity and the relative permittivity were 7.30 µF/cm² and 1,650 respectively which were small. With regard to the thin films of Comparative examples 47 to 50, the added amount of the PVP was 1.5 mole% (molar ratio = PVP/formed PZT molecules = 1.5/100 = 0.015) which was excessively large, the electrical capacities were in a range of 6.73 µF/cm² to 6.86 µF/cm² which were small, and the relative permittivities were in a range of 1,520 to 1,550 which were small.
In contrast, with regard to the thin films of Examples 49 to 64, the added amounts of the PVP were in an appropriate range of 0.1 mole% to 1.0 mole% (molar ratio = PVP/formed PZT molecules = (0.1 to 1.0)/100 = 0.001 to 0.01), and it was found that the electrical capacities increased to 7.70 µF/cm² to 8.94 µF/cm² and the relative permittivities increased to 1,740 to 2,020, respectively.
With regard to the thin films of Comparative examples 51, 53, 55, 57, and 59, the molecular weight of the PVP was 3,000 which was small, the electrical capacities were in a range of 7.17 µF/cm² to 7.26 µF/cm² which were small, and the relative permittivities were in a range of 1,620 to 1,640 which were small, respectively. With regard to the thin films of Comparative examples 52, 54, 56, 58, and 60, the molecular weight of the PVP was 200,000 which was excessively large, the electrical capacities were in a range of 6.64 µF/cm² to 7.21 µF/cm² which were small, and the relative permittivities were in a range of 1,500 to 1,630 which were small, respectively.
In contrast, with regard to the thin films of Examples 49 to 64, the molecular weights of the PVP were in an appropriate range of 5,000 to 100,000, and it was found that the electrical capacities increased to 7.70 µF/cm² to 8.94 µF/cm² and the relative permittivities increased to 1,740 to 2,020, respectively.

### <Example 65>

Firstly, Ti isopropoxide (Ti source) and acetylacetone (stabilizing agent) were fed into a reaction vessel and the mixture was refluxed in a nitrogen atmosphere so as to obtain an organic metal compound containing Ti. Next, lead acetate trihydrate (Pb source) and propylene glycol (solvent) were added to the organic metal compound containing Ti, and the mixture was refluxed in a nitrogen atmosphere. Then, the resultant product was distilled at a reduced pressure so as to remove byproducts. Thereby, an organic metal compound solution having a ratio of the respective metals Pb/La/Zr/Ti of 125/0/0/100 was obtained. The organic metal compound solution contained metal elements in a ratio that satisfied a composition formula (PbₓLa_{y})(Zr_{z}Ti_{(1-z)}) (x = 1.25, y = 0, and z = 0).
Next, a diluted alcohol was added to the organic metal compound solution so as to adjust the oxide-converted concentration of the organic metal compound to 10% by mass. Polyvinylpyrrolidone (weight-average molecular weight: 5,000) was added to the organic metal compound solution so as to obtain a composition 5. Here, the added amount of the polyvinylpyrrolidone was adjusted so that the ratio (percentage) of the molar number of the amount of the monomer-converted polyvinylpyrrolidone to the molar number of the amount of Ti included in the organic metal compound solution (the molar number ofPT molecules to be formed) became 0.1 mole%. Furthermore, the particles of byproducts were removed.
Next, a substrate was manufactured using the following method. Firstly, a Si single crystal base material having the surface of a (100) plane was prepared. The surface of the Si base material was oxidized, and a SiO₂ layer was formed in the surface of the Si base material. In addition, a TiO₂ layer and a Pt layer were deposited in this order on the SiO₂ layer. Thereby, a heat-resistant laminate substrate having a Pt layer (top layer) / TiO₂ layer / SiO₂ layer / Si base material [the surface (crystal orientation plane) of the Si base material: (100) plane] structure was manufactured.
The composition 5 was coated on the Pt layer of the substrate by a spin coating method so as to form a coated film. Next, the coated film on the substrate was heated at 350°C (a temperature that is lower than the crystallization temperature of the coated film) in air so as to be dried.
The coating process and the drying process were repeated a predetermined number of times. Subsequently, the coated film on the substrate was subjected to a rapid thermal annealing (RTA) thermal treatment in an oxygen atmosphere under conditions where an achieved temperature was 700°C (a temperature that is equal to or higher than the crystallization temperature of the coated film). Thereby, the coated film was fired, and a ferroelectric thin film having a thickness of 180 nm was manufactured on the substrate. The thin film was considered to be Example 65.

### <Examples 66 to 68>

Thin films were manufactured on substrates in the same manner as in Example 65 except that the weight-average molecular weights of the polyvinylpyrrolidone were 10,000, 50,000, and 100,000, respectively. The thin films were considered to be Examples 66, 67, and 68 respectively.

### <Examples 69 to 72>

Thin films were manufactured on substrates in the same manner as in Example 65 except that the ratio (percentage) of the molar number of the amount of the monomer-converted polyvinylpyrrolidone to the molar number of the amount of Ti included in the composition 5 (the molar number of formed PT molecules) was 0.3 mole%, and the weight-average molecular weights of the polyvinylpyrrolidone were 5,000, 10,000, 50,000, and 100,000, respectively. The thin films were considered to be Examples 69, 70, 71, and 72 respectively.

### <Examples 73 to 76>

Thin films were manufactured on substrates in the same manner as in Example 65 except that the ratio (percentage) of the molar number of the amount of the monomer-converted polyvinylpyrrolidone to the molar number of the amount of Ti included in the composition 5 (the molar number of formed PT molecules) was 0.5 mole%, and the weight-average molecular weights of the polyvinylpyrrolidone were 5,000, 10,000, 50,000, and 100,000, respectively. The thin films were considered to be Examples 73, 74, 75, and 76 respectively.

### <Examples 77 to 80>

Thin films were manufactured on substrates in the same manner as in Example 65 except that the ratio (percentage) of the molar number of the amount of the monomer-converted polyvinylpyrrolidone to the molar number of the amount of Ti included in the composition 5 (the molar number of formed PT molecules) was 1.0 mole%, and the weight-average molecular weights of the polyvinylpyrrolidone were 5,000, 10,000, 50,000, and 100,000, respectively. The thin films were considered to be Examples 77, 78, 79, and 80, respectively.

### <Comparative example 61>

A thin film was manufactured on a substrate in the same manner as in Example 65 except that the polyvinylpyrrolidone was not added to the organic metal compound solution. The thin film was considered to be Comparative example 61.

### <Comparative examples 62 to 65>

Thin films were manufactured on substrates in the same manner as in Example 65 except that the ratio (percentage) of the molar number of the amount of the monomer-converted polyvinylpyrrolidone to the molar number of the amount of Ti included in the composition 5 (the molar number of formed PT molecules) was 1.5 mole%, and the weight-average molecular weights of the polyvinylpyrrolidone were 5,000, 10,000, 50,000, and 100,000, respectively. The thin films were considered to be Comparative examples 62, 63, 64, and 65 respectively.

### <Comparative examples 66 and 67>

Thin films were manufactured on substrates in the same manner as in Example 65 except that the weight-average molecular weights of the polyvinylpyrrolidone were 3,000 and 200,000, respectively. The thin films were considered to be Comparative examples 66 and 67, respectively.

### <Comparative examples 68 and 69>

Thin films were manufactured on substrates in the same manner as in Example 65 except that the ratio (percentage) of the molar number of the amount of the monomer-converted polyvinylpyrrolidone to the molar number of the amount of Ti included in the composition 5 (the molar number of formed PT molecules) was 0.3 mole%, and the weight-average molecular weights of the polyvinylpyrrolidone were 3,000 and 200,000, respectively. The thin films were considered to be Comparative examples 68 and 69 respectively.

### <Comparative examples 70 and 71>

Thin films were manufactured on substrates in the same manner as in Example 65 except that the ratio (percentage) of the molar number of the amount of the monomer-converted polyvinylpyrrolidone to the molar number of the total amount of Ti included in the composition 5 (the molar number of formed PT molecules) was 0.5 mole%, and the weight-average molecular weights of the polyvinylpyrrolidone were 3,000 and 200,000, respectively. The thin films were considered to be Comparative examples 70 and 71, respectively.

### <Comparative examples 72 and 73>

Thin films were manufactured on substrates in the same manner as in Example 65 except that the ratio (percentage) of the molar number of the amount of the monomer-converted polyvinylpyrrolidone to the molar number of the amount of Ti included in the composition 5 (the molar number of formed PT molecules) was 1.0 mole%, and the weight-average molecular weights of the polyvinylpyrrolidone were 3,000 and 200,000, respectively. The thin films were considered to be Comparative examples 72 and 73, respectively.

### <Comparative examples 74 and 75>

Thin films were manufactured on substrates in the same manner as in Example 65 except that the ratio (percentage) of the molar number of the amount of the monomer-converted polyvinylpyrrolidone to the molar number of the amount of Ti included in the composition 5 (the molar number of formed PT molecules) was 1.5 mole%, and the weight-average molecular weights of the polyvinylpyrrolidone were 3,000 and 200,000, respectively. The thin films were considered to be Comparative examples 74 and 75 respectively.

### <Comparison test 5 and evaluation>

The electrical capacity and the relative permittivity of each of the thin films of Examples 65 to 80 and Comparative examples 61 to 75 were measured. Specific measurements of the electrical capacity and the relative permittivity of the ferroelectric thin film were carried out by the same methods as in the comparison test 1.
The obtained results are shown in Table 5. Meanwhile, Table 5 shows the Pb/La/Zr/Ti ratio in the composition 5, the stabilizing agents used to manufacture the composition 2, the molecular weights and the added amounts of the polyvinylpyrrolidone (PVP) included in the composition 5, and the firing atmospheres of the thin films respectively together with the electrical capacity and relative permittivity of the thin films.

**Table 5**

| | Pb/La/Zr/Ti | Stabilizing agent | Polyvinylpyrrolidone | | Firing atmosphere | Electrical capacity (µF/cm²) | Relative permittivity |
|---|---|---|---|---|---|---|---|
| | | | Molecular weight | Added amount (mole%) | | | |
| Example 65 | 125/0/0/100 | Acetylacetone | 5000 | 0.1 | Oxygen | 0.66 | 150 |
| Example 66 | Same as above | Same as above | 10000 | 0.1 | Same as above | 0.66 | 150 |
| Example 67 | Same as above | Same as above | 50000 | 0.1 | Same as above | 0.75 | 170 |
| Example 68 | Same as above | Same as above | 100000 | 0.1 | Same as above | 0.75 | 170 |
| Example 69 | Same as above | Same as above | 5000 | 0.3 | Same as above | 0.71 | 160 |
| Example 70 | Same as above | Same as above | 10000 | 0.3 | Same as above | 0.80 | 180 |
| Example 71 | Same as above | Same as above | 50000 | 0.3 | Same as above | 0.80 | 180 |
| Example 72 | Same as above | Same as above | 100000 | 0.3 | Same as above | 0.75 | 170 |
| Example 73 | Same as above | Same as above | 5000 | 0.5 | Same as above | 0.75 | 170 |
| Example 74 | Same as above | Same as above | 10000 | 0.5 | Same as above | 0.80 | 180 |
| Example 75 | Same as above | Same as above | 50000 | 0.5 | Same as above | 0.84 | 190 |
| Example 76 | Same as above | Same as above | 100000 | 0.5 | Same as above | 0.80 | 180 |
| Example 77 | Same as above | Same as above | 5000 | 1.0 | Same as above | 0.66 | 150 |
| Example 78 | Same as above | Same as above | 10000 | 1.0 | Same as above | 0.71 | 160 |
| Example 79 | Same as above | Same as above | 50000 | 1.0 | Same as above | 0.75 | 170 |
| Example 80 | Same as above | Same as above | 100000 | 1.0 | Same as above | 0.71 | 160 |
| Comparative example 61 | 125/0/0/100 | Acetylacetone | - | - | Oxygen | 0.58 | 130 |
| Comparative example 62 | Same as above | Same as above | 5000 | 1.5 | Same as above | 0.53 | 120 |
| Comparative example 63 | Same as above | Same as above | 10000 | 1.5 | Same as above | 0.53 | 120 |
| Comparative example 64 | Same as above | Same as above | 50000 | 1.5 | Same as above | 0.53 | 120 |
| Comparative example 65 | Same as above | Same as above | 100000 | 1.5 | Same as above | 0.49 | 110 |
| Comparative example 66 | Same as above | Same as above | 3000 | 0.1 | Same as above | 0.58 | 130 |
| Comparative example 67 | Same as above | Same as above | 200000 | 0.1 | Same as above | 0.53 | 120 |
| Comparative example 68 | Same as above | Same as above | 3000 | 0.3 | Same as above | 0.58 | 130 |
| Comparative example 69 | Same as above | Same as above | 200000 | 0.3 | Same as above | 0.49 | 110 |
| Comparative example 70 | Same as above | Same as above | 3000 | 0.5 | Same as above | 0.53 | 120 |
| Comparative example 71 | Same as above | Same as above | 200000 | 0.5 | Same as above | 0.49 | 110 |
| Comparative example 72 | Same as above | Same as above | 3000 | 1.0 | Same as above | 0.49 | 110 |
| Comparative example 73 | Same as above | Same as above | 200000 | 1.0 | Same as above | 0.53 | 120 |
| Comparative example 74 | Same as above | Same as above | 3000 | 1.5 | Same as above | 0.49 | 110 |
| Comparative example 75 | Same as above | Same as above | 200000 | 1.5 | Same as above | 0.49 | 110 |

As it is evident from Table 5, with regard to the thin film of Comparative example 61, no polyvinylpyrrolidone (PVP) was added, the electrical capacity and the relative permittivity were 0.58 µF/cm² and 130 respectively which were small. With regard to the thin films of Comparative examples 62 to 65, the added amount of the PVP was 1.5 mole% (molar ratio = PVP/formed PT molecules = 1.5/100 = 0.015) which was excessively large, the electrical capacities were in a range of 0.49 µF/cm² to 0.53 µF/cm² which were small, and the relative permittivities were in a range of 110 to 120 which were small.
In contrast, with regard to the thin films of Examples 65 to 80, the added amounts of the PVP were in an appropriate range of 0.1 mole% to 1.0 mole% (molar ratio = PVP/formed PT molecules = (0.1 to 1.0)/100 = 0.001 to 0.01), and it was found that the electrical capacities increased to 0.66 µF/cm² to 0.84 µF/cm², and the relative permittivities increased to 150 to 190, respectively.
With regard to the thin films of Comparative examples 66, 68, 70, 72, and 74, the molecular weight of the PVP was 3,000 which was small, the electrical capacities were in a range of 0.49 µF/cm² to 0.58 µF/cm² which were small, and the relative permittivities were in a range of 110 to 130 which were small, respectively. With regard to the thin films of Comparative examples 67, 69, 71, 73, and 75, the molecular weight of the PVP was 200,000 which was excessively large, the electrical capacities were in a range of 0.49 µF/cm² to 0.53 µF/cm² which were small, and the relative permittivities were in a range of 110 to 120 which were small, respectively.
In contrast, with regard to the thin films of Examples 65 to 80, the molecular weights of the PVP were in an appropriate range of 5,000 to 100,000, and it was found that the electrical capacities increased to 0.66 µF/cm² to 0.84 µF/cm² and the relative permittivities increased to 150 to 190, respectively.

### <Example 81>

Firstly, Ti isopropoxide (Ti source) and diethanolamine (stabilizing agent) were fed into a reaction vessel and the mixture was refluxed in a nitrogen atmosphere so as to obtain an organic metal compound containing Ti. Next, lead acetate trihydrate (Pb source) and propylene glycol (solvent) were added to the organic metal compound containing Ti, and the mixture was refluxed in a nitrogen atmosphere. Then, the resultant product was distilled at a reduced pressure so as to remove byproducts. Thereby, an organic metal compound solution having a ratio of the respective metals Pb/La/Zr/Ti of 125/0/0/100 was obtained. The organic metal compound solution contained metal elements in a ratio that satisfied a composition formula (PbₓLa_{y})(Zr_{z}Ti_{(1-z)}) (x = 1.25, y = 0, and z = 0).
Next, a diluted alcohol was added to the organic metal compound solution so as to adjust the oxide-converted concentration of the organic metal compound to 10% by mass. Polyvinylpyrrolidone (weight-average molecular weight: 5,000) was added to the organic metal compound solution so as to obtain a composition 6. Here, the added amount of the polyvinylpyrrolidone was adjusted so that the ratio (percentage) of the molar number of the amount of the monomer-converted polyvinylpyrrolidone to the molar number of the amount of Ti included in the organic metal compound solution (the molar number of PT molecules to be formed) became 0.1 mole%. Furthermore, the particles of byproducts were removed.
Next, a substrate was manufactured using the following method. Firstly, a Si single crystal base material having the surface of a (100) plane was prepared. The surface of the Si base material was oxidized, and a SiO₂ layer was formed in the surface of the Si base material. In addition, a TiO₂ layer and a Pt layer were deposited in this order on the SiO₂ layer. Thereby, a heat-resistant laminate substrate having a Pt layer (top layer) / TiO₂ layer / SiO₂ layer / Si base material [the surface (crystal orientation plane) of the Si base material: (100) plane] structure was manufactured.
The composition 6 was coated on the Pt layer of the substrate by a spin coating method so as to form a coated film. Next, the coated film on the substrate was heated at 350°C (a temperature that is lower than the crystallization temperature of the coated film) in air so as to be dried.
The coating process and the drying process were repeated a predetermined number of times. Subsequently, the coated film on the substrate was subjected to a rapid thermal annealing (RTA) thermal treatment in dried air under conditions where an achieved temperature was 700°C (a temperature that is equal to or higher than the crystallization temperature of the coated film). Thereby, the coated film was fired, and a ferroelectric thin film having a thickness of 180 nm was manufactured on the substrate. The thin film was considered to be Example 81.

### <Examples 82 to 84>

Thin films were manufactured on substrates in the same manner as in Example 81 except that the weight-average molecular weights of the polyvinylpyrrolidone were 10,000, 50,000, and 100,000, respectively. The thin films were considered to be Examples 82, 83, and 84, respectively.

### <Examples 85 to 88>

Thin films were manufactured on substrates in the same manner as in Example 81 except that the ratio (percentage) of the molar number of the amount of the monomer-converted polyvinylpyrrolidone to the molar number of the amount of Ti included in the composition 6 (the molar number of formed PT molecules) was 0.3 mole%, and the weight-average molecular weights of the polyvinylpyrrolidone were 5,000, 10,000, 50,000, and 100,000, respectively. The thin films were considered to be Examples 85, 86, 87, and 88 respectively.

### <Examples 89 to 92>

Thin films were manufactured on substrates in the same manner as in Example 81 except that the ratio (percentage) of the molar number of the amount of the monomer-converted polyvinylpyrrolidone to the molar number of the amount of Ti included in the composition 6 (the molar number of formed PT molecules) was 0.5 mole%, and the weight-average molecular weights of the polyvinylpyrrolidone were 5,000, 10,000, 50,000, and 100,000, respectively. The thin films were considered to be Examples 89, 90, 91, and 92, respectively.

### <Examples 93 to 96>

Thin films were manufactured on substrates in the same manner as in Example 81 except that the ratio (percentage) of the molar number of the amount of the monomer-converted polyvinylpyrrolidone to the molar number of the amount of Ti included in the composition 6 (the molar number of formed PT molecules) was 1.0 mole%, and the weight-average molecular weights of the polyvinylpyrrolidone were 5,000, 10,000, 50,000, and 100,000, respectively. The thin films were considered to be Examples 93, 94, 95, and 96 respectively.

### <Comparative example 76>

A thin film was manufactured on a substrate in the same manner as in Example 81 except that the polyvinylpyrrolidone was not added to the organic metal compound solution. The thin film was considered to be Comparative example 76.

### <Comparative examples 77 to 80>

Thin films were manufactured on substrates in the same manner as in Example 81 except that the ratio (percentage) of the molar number of the amount of the monomer-converted polyvinylpyrrolidone to the molar number of the amount of Ti included in the composition 6 (the molar number of formed PT molecules) was 1.5 mole%, and the weight-average molecular weights of the polyvinylpyrrolidone were 5,000, 10,000, 50,000, and 100,000, respectively. The thin films were considered to be Comparative examples 77, 78, 79, and 80, respectively.

### <Comparative examples 81 and 82>

Thin films were manufactured on substrates in the same manner as in Example 81 except that the weight-average molecular weights of the polyvinylpyrrolidone were 3,000 and 200,000, respectively. The thin films were considered to be Comparative examples 81 and 82, respectively.

### <Comparative examples 83 and 84>

Thin films were manufactured on substrates in the same manner as in Example 81 except that the ratio (percentage) of the molar number of the amount of the monomer-converted polyvinylpyrrolidone to the molar number of the amount of Ti included in the composition 6 (the molar number of formed PT molecules) was 0.3 mole%, and the weight-average molecular weights of the polyvinylpyrrolidone were 3,000 and 200,000, respectively. The thin films were considered to be Comparative examples 83 and 84, respectively.

### <Comparative examples 85 and 86>

Thin films were manufactured on substrates in the same manner as in Example 81 except that the ratio (percentage) of the molar number of the amount of the monomer-converted polyvinylpyrrolidone to the molar number of the amount of Ti included in the composition 6 (the molar number of formed PT molecules) was 0.5 mole%, and the weight-average molecular weights of the polyvinylpyrrolidone were 3,000 and 200,000, respectively. The thin films were considered to be Comparative examples 85 and 86, respectively.

### <Comparative examples 87 and 88>

Thin films were manufactured on substrates in the same manner as in Example 81 except that the ratio (percentage) of the molar number of the amount of the monomer-converted polyvinylpyrrolidone to the molar number of the amount of Ti included in the composition 6 (the molar number of formed PT molecules) was 1.0 mole%, and the weight-average molecular weights of the polyvinylpyrrolidone were 3,000 and 200,000, respectively. The thin films were considered to be Comparative examples 87 and 88, respectively.

### <Comparative examples 89 and 90>

Thin films were manufactured on substrates in the same manner as in Example 81 except that the ratio (percentage) of the molar number of the amount of the monomer-converted polyvinylpyrrolidone to the molar number of the amount of Ti included in the composition 6 (the molar number of formed PT molecules) was 1.5 mole%, and the weight-average molecular weights of the polyvinylpyrrolidone were 3,000 and 200,000, respectively. The thin films were considered to be Comparative examples 89 and 90, respectively.

### <Comparison test 6 and evaluation>

The electrical capacity and the relative permittivity of each of the thin films of Examples 81 to 96 and Comparative examples 76 to 90 were measured. Specific measurements of the electrical capacity and the relative permittivity of the ferroelectric thin film were carried out by the same methods as in the comparison test 1.
The obtained results are shown in Table 6. Meanwhile, Table 6 shows the Pb/La/Zr/Ti ratio in the composition 6, the stabilizing agents used to manufacture the composition 6, the molecular weights and the added amounts of the polyvinylpyrrolidone (PVP) included in the composition 6, and the firing atmospheres of the thin films respectively together with the electrical capacity and relative permittivity of the thin films.

**Table 6**

| | Pb/La/Zr/Ti | Stabilizing agent | Polyvinylpyrrolidone | | Firing atmosphere | Electrical capacity (µF/cm²) | Relative permittivity |
|---|---|---|---|---|---|---|---|
| | | | Molecular weight | Added amount (mole%) | | | |
| Example 81 | 125/0/0/100 | Diethanolamine | 5000 | 0.1 | Dried air | 0.62 | 140 |
| Example 82 | Same as above | Same as above | 10000 | 0.1 | Same as above | 0.71 | 160 |
| Example 83 | Same as above | Same as above | 50000 | 0.1 | Same as above | 0.75 | 170 |
| Example 84 | Same as above | Same as above | 100000 | 0.1 | Same as above | 0.62 | 140 |
| Example 85 | Same as above | Same as above | 5000 | 0.3 | Same as above | 0.66 | 150 |
| Example 86 | Same as above | Same as above | 10000 | 0.3 | Same as above | 0.80 | 180 |
| Example 87 | Same as above | Same as above | 50000 | 0.3 | Same as above | 0.80 | 180 |
| Example 88 | Same as above | Same as above | 100000 | 0.3 | Same as above | 0.66 | 150 |
| Example 89 | Same as above | Same as above | 5000 | 0.5 | Same as above | 0.66 | 150 |
| Example 90 | Same as above | Same as above | 10000 | 0.5 | Same as above | 0.84 | 190 |
| Example 91 | Same as above | Same as above | 50000 | 0.5 | Same as above | 0.80 | 180 |
| Example 92 | Same as above | Same as above | 100000 | 0.5 | Same as above | 0.62 | 140 |
| Example 93 | Same as above | Same as above | 5000 | 1.0 | Same as above | 0.62 | 140 |
| Example 94 | Same as above | Same as above | 10000 | 1.0 | Same as above | 0.75 | 170 |
| Example 95 | Same as above | Same as above | 50000 | 1.0 | Same as above | 0.75 | 170 |
| Example 96 | Same as above | Same as above | 100000 | 1.0 | Same as above | 0.71 | 160 |
| Comparative example 76 | 125/0/0/100 | Diethanolamine | - | - | Dried air | 0.53 | 120 |
| Comparative example 77 | Same as above | Same as above | 5000 | 1.5 | Same as above | 0.49 | 110 |
| Comparative example 78 | Same as above | Same as above | 10000 | 1.5 | Same as above | 0.53 | 120 |
| Comparative example 79 | Same as above | Same as above | 50000 | 1.5 | Same as above | 0.58 | 130 |
| Comparative example 80 | Same as above | Same as above | 100000 | 1.5 | Same as above | 0.49 | 110 |
| Comparative example 81 | Same as above | Same as above | 3000 | 0.1 | Same as above | 0.53 | 120 |
| Comparative example 82 | Same as above | Same as above | 200000 | 0.1 | Same as above | 0.44 | 100 |
| Comparative example 83 | Same as above | Same as above | 3000 | 0.3 | Same as above | 0.49 | 110 |
| Comparative example 84 | Same as above | Same as above | 200000 | 0.3 | Same as above | 0.44 | 100 |
| Comparative example 85 | Same as above | Same as above | 3000 | 0.5 | Same as above | 0.53 | 120 |
| Comparative example 86 | Same as above | Same as above | 200000 | 0.5 | Same as above | 0.49 | 110 |
| Comparative example 87 | Same as above | Same as above | 000 | 1.0 | Same as above | 0.49 | 110 |
| Comparative example 88 | Same as above | Same as above | 200000 | 1.0 | Same as above | 0.44 | 100 |
| Comparative example 89 | Same as above | Same as above | 3000 | 1.5 | Same as above | 0.49 | 110 |
| Comparative example 90 | Same as above | Same as above | 200000 | 1.5 | Same as above | 0.44 | 100 |

As it is evident from Table 6, with regard to the thin film of Comparative example 76, no polyvinylpyrrolidone (PVP) was added, and the electrical capacity and the relative permittivity were 0.53 µF/cm² and 120 respectively which were small. With regard to the thin films of Comparative examples 77 to 80, the added amount of the PVP was 1.5 mole% (molar ratio = PVP/formed PT molecules = 1.5/100 = 0.015) which was excessively large, the electrical capacities were in a range of 0.49 µF/cm² to 0.58 µF/cm² which were small, and the relative permittivities were in a range of 110 to 130 which were small.
In contrast, with regard to the thin films of Examples 81 to 96, the added amounts of the PVP was in an appropriate range of 0.1 mole% to 1.0 mole% (molar ratio = PVP/formed PT molecules = (0.1 to 1.0)/100 = 0.001 to 0.01), and it was found that the electrical capacities increased to 0.62 µF/cm² to 0.84 µF/cm², and the relative permittivities increased to 140 to 190, respectively.
With regard to the thin films of Comparative examples 81, 83, 85, 87, and 89, the molecular weight of the PVP was 3,000 which was small, the electrical capacities were in a range of 0.49 µF/cm² to 0.53 µF/cm² which were small, and the relative permittivities were in a range of 110 to 120 which were small, respectively. With regard to the thin films of Comparative examples 82, 84, 86, 88, and 90, the molecular weight of the PVP was 200,000 which was excessively large, the electrical capacities were in a range of 0.44 µF/cm² to 0.49 µF/cm² which were small, and the relative permittivities were in a range of 100 to 110 which were small, respectively.
In contrast, with regard to the thin films of Examples 81 to 96, the molecular weights of the PVP were in an appropriate range of 5,000 to 100,000, and it was found that the electrical capacities increased to 0.62 µF/cm² to 0.84 µF/cm² and the relative permittivities increased to 140 to 190, respectively.

### INDUSTRIAL APPLICABILITY

The ferroelectric thin film of the embodiment can be used for a thin film capacitor having a high capacity and a high density. In addition to the thin film capacitor, the ferroelectric thin film of the embodiment can be used for complex electronic components such as IPDs, DRAM memory capacitors, laminate capacitors, gate insulators of transistors, non-volatile memories, pyroelectric infrared detecting elements, piezoelectric elements, electro-optic elements, actuators, resonators, ultrasonic motors, surface acoustic wave elements, transducers, and LC noise filter elements. Therefore, the composition for forming a ferroelectric thin film and the method for forming a ferroelectric thin film of the embodiment can be used in manufacturing processes of the thin film capacitors or the complex electronic components.

## Claims

1. A composition for forming a ferroelectric thin film which is a composition for forming a ferroelectric thin film consisting of a lead titanate-based perovskite film or a lead zirconate titanate-based complex perovskite film,
the composition comprising: lead acetate; a stabilizing agent consisting of acetylacetone or diethanolamine; and polyvinylpyrrolidone,
wherein a ratio of a molar number of monomer-converted polyvinylpyrrolidone to a molar number of perovskite B site atoms included in the composition is in a range of more than 0 to less than 0.015, and
a weight-average molecular weight of the polyvinylpyrrolidone is in a range of 5,000 to 100,000.

2. The composition for forming a ferroelectric thin film according to Claim 1,
wherein the lead titanate-based perovskite film or the lead zirconate titanate-based perovskite film is represented by a general formula [(PbₓLa_{y})(Zr_{z}Ti(_{1-z}))O₃], and, in the general formula, 0.9 < x < 1.3, 0 ≤ y < 0.1, and 0 ≤ z < 0.9 are fulfilled.

3. The composition for forming a ferroelectric thin film according to Claim 1,
wherein the composition further comprises a raw material containing metal elements that form the lead titanate-based perovskite film or the lead zirconate titanate-based complex perovskite film, and
the raw material is a compound in which organic groups are bound to the metal elements through oxygen atoms or nitrogen atoms.

4. The composition for forming a ferroelectric thin film according to Claim 3,
wherein the raw material containing metal elements that form the lead titanate-based perovskite film or the lead zirconate titanate-based complex perovskite film is one or more selected from a group consisting of organic acid salts, metal alkoxides, metal β-diketonate complexes, metal β-diketoester complexes, metal β-iminoketo complexes, and metal amino complexes.

5. The composition for forming a ferroelectric thin film according to Claim 1,
wherein an amount of the stabilizing agent is in a range of 0.2 parts by mole to 3 parts by mole with respect to one part by mole of a total amount of the metal elements in the composition.

6. The composition for forming a ferroelectric thin film according to Claim 1,
wherein a ratio of a molar number of monomer-converted polyvinylpyrrolidone to a molar number of perovskite B site atoms included in the composition is in a range of 0.001 to 0.01.

7. A method for forming a ferroelectric thin film comprising:
a coating process in which the composition for forming a ferroelectric thin film according to Claims 1 is coated on a substrate so as to form a coated film;
a drying process in which the coated film formed on the substrate is heated and dried in an atmosphere selected from air, an oxidization atmosphere, and a water vapor-containing atmosphere; and
a firing process in which the coated film is fired at a temperature of not lower than a crystallization temperature in an atmosphere consisting of one or more gases selected from O₂, N₂, Ar, N₂O, H₂, dried air, and water vapor from a middle of the drying process or after completion of the drying process.

8. A method for forming a ferroelectric thin film comprising:
a coating process in which the composition for forming a ferroelectric thin film according to Claim 1 is coated on a substrate so as to form a coated film;
a drying process in which the coated film formed on the substrate is heated and dried in any atmosphere selected from air, an oxidization atmosphere, and a water vapor-containing atmosphere;
a repetition process in which the coating process and the drying process are repeated a plurality of times; and
a firing process in which the coated film is fired at a temperature of not lower than a crystallization temperature in an atmosphere consisting of one or more gases selected from O₂, N₂, Ar, N₂O, H₂, dried air, and water vapor from a middle of a final drying process in the repetition process or after completion of the final drying process in the repetition process.

9. A ferroelectric thin film which is formed by the method according to Claim 7 or 8.

10. A complex electronic component comprising an element having the ferroelectric thin film of Claim 9,
wherein the element is any one selected from thin film capacitors, capacitors, IPDs, DRAM memory capacitors, laminate capacitors, gate insulators of transistors, non-volatile memories, pyroelectric infrared detecting elements, piezoelectric elements, electro-optic elements, actuators, resonators, ultrasonic motors, surface acoustic wave elements, transducers, and LC noise filter elements.

11. A complex electronic component comprising an element having the ferroelectric thin film according to Claim 9 which corresponds to a frequency range of 100 MHz or more,
wherein the element is any one selected from thin film capacitors, capacitors, IPDs, DRAM memory capacitors, laminate capacitors, gate insulators of transistors, non-volatile memories, pyroelectric infrared detecting elements, piezoelectric elements, electro-optic elements, actuators, resonators, ultrasonic motors, surface acoustic wave elements, transducers, and LC noise filter elements.
